(19) Europäisches Patentamt
European Patent Office
Office européen des brevets

(11) EP 4 362 650 B1

(12) **EUROPEAN PATENT SPECIFICATION**

(45) Date of publication and mention of the grant of the patent:
**06.08.2025 Bulletin 2025/32**

(21) Application number: **22204790.4**

(22) Date of filing: **31.10.2022**

(51) International Patent Classification (IPC):
***H10N 50/10*** *(2023.01)* ***H10N 50/01*** *(2023.01)*
***H10B 61/00*** *(2023.01)*

(52) Cooperative Patent Classification (CPC):
**H10N 50/10; H10B 61/00; H10N 50/01**

(54) **MAGNETIC TUNNEL JUNCTION, ARRAY OF MAGNETIC TUNNEL JUNCTIONS, AND ASSOCIATED FABRICATION METHOD**

MAGNETTUNNELÜBERGANG, ARRAY VON MAGNETTUNNELÜBERGÄNGEN UND ZUGEHÖRIGES HERSTELLUNGSVERFAHREN

JONCTION TUNNEL MAGNÉTIQUE, RÉSEAU DE JONCTIONS TUNNEL MAGNÉTIQUES ET PROCÉDÉ DE FABRICATION ASSOCIÉ

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**01.05.2024 Bulletin 2024/18**

(73) Proprietors:
- **Commissariat à l'Energie Atomique et aux Energies Alternatives**
  **75015 Paris (FR)**
- **Centre national de la recherche scientifique**
  **75016 Paris (FR)**
- **Université Grenoble Alpes**
  **38400 Saint-Martin-d'Hères (FR)**
- **Institut Polytechnique de Grenoble**
  **38000 Grenoble (FR)**

(72) Inventors:
- **Fernandes Caçoilo, Nuno-Filipe**
  **38054 GRENOBLE CEDEX 09 (FR)**
- **Prejbeanu, Ioan-Lucian**
  **38054 GRENOBLE CEDEX 09 (FR)**
- **Fruchart, Olivier**
  **38054 GRENOBLE CEDEX 09 (FR)**
- **Dieny, Bernard**
  **38054 GRENOBLE CEDEX 09 (FR)**
- **Sousa, Ricardo**
  **38054 GRENOBLE CEDEX 09 (FR)**

(74) Representative: **Cabinet Camus Lebkiri**
**25 rue de Maubeuge**
**75009 Paris (FR)**

(56) References cited:
**US-A1- 2010 102 406** **US-A1- 2014 177 326**
**US-A1- 2019 326 508** **US-B1- 6 531 723**

- **HA Y K ET AL: "MRAM with novel shaped cell using synthetic anti-ferromagnetic free layer", 2004 SYMPOSIUM ON VLSI TECHNOLOGY, HONOLULU, HI, USA, 15-17 JUNE 2004, 15 June 2004 (2004-06-15), pages 24 - 25, XP010733000, DOI: 10.1109/VLSIT.2004.1345371**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 362 650 B1

## Description

### TECHNICAL FIELD OF THE INVENTION

The technical field of the invention concerns magnetic tunnel junctions such as one being implemented in magnetic random-access memories and the like or magnetic sensors and the like, said magnetic tunnel junctions attended to be arranged in arrays.

### PRIOR ART

The spin-transfer torque magnetic random-access memory (or "STT-MRAM") is one of the most promising emerging non-volatile memory technologies. It combines non-volatility with a quasi-infinite write endurance, high speed, low power consumption and scalability. These properties have stimulated the commercial production of STT-MRAM for a variety of stand-alone and embedded applications, in particular NOR flash memory replacement and last-level cache static RAM (or "SRAM") replacement.

A STT-RAM is based on a magnetic tunnel junction (or "MTJ"), said MTJ comprising a reference layer and a free layer, separated by a tunnel layer. The reference layer has a magnetization with a fixed orientation and the free layer has a magnetization with a switchable orientation. MTJs with synthetic antiferromagnetic (SAF) free layer structure, comprising at least two planar magnetic layers antiferromagnetically coupled by a spacer layer, are known from US 6,531,723 B1 or Y.K. Ha et al., "MRAM with novel shaped cell using synthetic anti-ferromagnetic free layer", 2004 Symposium on VLSI Technology, pp. 24-25, for example.

Nowadays MTJ rely on out-of-plane orientation of the magnetizations in the free and the reference layers (the out-of-plane orientation being considered with respect to the plane of the free layer of MTJ). This has been shown to lead to a better scalability of the thermal stability factor $\Delta$

$$\Delta = \frac{E_B}{k_B\, T}$$

where $E_B$ is the energy barrier one needs to overcome to reverse the magnetization from an out-of-plane orientation to an opposite one, $k_B$ is the Boltzmann constant and T is the operating temperature. The thermal stability factor determines the memory retention time and impacts the switching current needed to switch the magnetization from one orientation to another one.

Specific devices, called perpendicular MTJ (or "p-MTJ"), rely on the use of an interfacial magnetic anisotropy existing at the interface between a free layer, usually based on FeCoB, and a MgO layer (such as the tunnel barrier). The interfacial magnetic anisotropy tends to overcome the shape to orient the magnetization out of the plane of the free layer.

Nonetheless, further downsize scalability of these p-MTJ below sub-20 nm diameters faces a fundamental challenge. As the diameter of the junction shrinks, there is a decrease of the thermal stability factor $\Delta$ brought by the interfacial perpendicular magnetic anisotropy. This can be understood considering that the interfacial perpendicular magnetic anisotropy energy is roughly proportional to the surface area of the free layer.

A proposal to counter this decrease of stability is to add FeCoB/MgO interfaces to increase the total surface providing the interfacial perpendicular magnetic anisotropy. Nevertheless, this approach is quite restrictive in terms of material choice, dependent on the quality of the several interfaces and has a strong dependence with temperature.

To maintain a high thermal stability factor at low technological nodes, the document [N. Perrissin & al., "A highly thermally stable sub-20 nm magnetic random-access memory based on perpendicular shape anisotropy", Nanoscale 10, 12187-12195 (2018)] suggests taking advantage of the shape anisotropy of the free layer by increasing its thickness to values of the order or larger than the free layer diameter. Thereby, the shape anisotropy of the free layer no longer promotes an easy-plane orientation but further stabilizes the magnetization along a perpendicular orientation (with respect to the plane of the free layer). This can be understood considering the magnetostatic energy of a magnetized cylinder, as expressed in [M. Beleggia et al., "Demagnetizing factors for cylindrical shells and related shapes", Journal of Magnetism and Magnetic Materials 321, 1306-1315 (2009)]:

$$E_m = \frac{\mu_0\, M_0^2\, r^3}{6}\left[4(3m_z^2-1) + 6\pi\tau m_z^2 - 3\pi\sqrt{1+\tau^2}(3m_z^2-1)\ \Gamma_2^1\left(-\frac{1}{2},\frac{3}{2};2;\frac{1}{1+\tau^2}\right)\right]$$

with $\tau$ the ratio $\frac{L}{2r}$ (L being the thickness of the free layer and r its radius), $\Gamma_2^1$ a hypergeometric function, and $m_z$ the defined orientation of the magnetization of the free layer with a saturation magnetisation $M_0$ and a vacuum permeability $\mu_0$.

The FIG. 1a shows an example of the magnetostatic energy of a free layer against its aspect ratio (thickness against diameter) considering two distinct orientations of the magnetization (in the plane of said free layer and perpendicular the said plane). Results are obtained considering a uniform magnetization of 1 MA/m. The FIG. 1a shows a clear crossover between the in-plane orientation (black arrow and cross-hatched region) and the out-of-plane orientation (white arrow and plain black region). Moreover, this crossover is geometry dependent, and the magnitude of the magnetization is only playing a role in the strength of the magnetostatic energy. The total energy barrier can be expanded considering the magnetostatic energy presented previously and introducing the contribution of the interfacial anisotropy, defined by a surface anisotropy term $k_s$, with a usual value of 1.4 mJ/m$^2$. With this approach it is possible to maintain a high enough thermal stability factor to sub-10 nm diameters MTJ. The FIG. 1b shows a thermal stability factor $\Delta$ for a free layer of different aspect ratios with a magnetization saturation of 1 MA/m and a surface anisotropy term $k_s$ of 1.4 mJ/m$^2$ for an operation temperature of 300 K. It shows that, by increasing the thickness of the free layer, for a fixed diameter value, it is possible to increase the thermal stability factor $\Delta$. This increase is stronger as the different anisotropy sources are increased, opening different possibilities of engineering this free layer.

The perpendicular shape-anisotropy (also called "PSA") provided by the thick free layer is drawing attention due to its scalability and wide temperature operation range. FIG. 2A shows an example of a magnetoresistive device comprising a p-MTJ 1a. FIG. 2B shows an example of a magnetoresistive device comprising a PSA magnetic tunnel junction 1b (also noted "PSA-MTJ"). Such a PSA-MTJ is disclosed in US 2019/0326508 A1, for example. In both cases, the devices 1a, 1b are composed of a seed layer 11, a synthetic antiferromagnet 12 followed by a texture breaker 13 and an out-of-plane magnetized reference layer 14. In each magnetic junction 1a, 1b, the reference layer 14 is separated from a thin free layer 16a by a tunnel barrier 15. Each thin free layer 16a exhibits an out-of-plane magnetization due to the interfacial effect between said thin free layer 16a and the tunnel barrier 15 it lies on.

The PSA-MTJ 1b of FIG. 2B differs from the p-MTJ 1a of FIG. 2A in that it comprises a ticker free layer 16b staked on top of the thin one 16a, to promote a shape anisotropy that allows for higher stability. This additional layer 16b is called "perpendicular shape anisotropy layer" or "PSA layer", while the thin free layer 16a is called "perpendicular interfacial anisotropy layer" or "interfacial anisotropy layer".

When discussing a p-MTJ, only the contribution of the interfacial anisotropy layer 16a is considered. When discussing a PSA-MTJ, both the contributions of the interfacial anisotropy layer 16a and the PSA layer 16b are considered.

Even though the perpendicular shape-anisotropy approach to engineer a free layer of a MTJ is shown as a viable candidate for a small diameter non-volatile MTJ, some challenges still need to be overcome. Indeed, it has been shown that the increased aspect-ratio of the PSA-layer 16b has an impact on the reversal mechanism driven by spin-transfer-torque, which can be avoided by considering the thickness of the PSA-layer 16b and the width of the domain-wall that can be formed in the PSA-layer 16b. The reversal mechanism is improved by keeping the aspect-ratio of the PSA-layer 16b (thickness over width) small enough, as disclosed by the document [N. Caçoilo et al., "Spin-Torque-Triggered Magnetization Reversal in Magnetic Tunnel Junctions with Perpendicular Shape Anisotropy", Physical Review Applied 16, 024020 (2021).

Thus, there is a need to reduce the total thickness of the free layer while keeping a stable out of plane magnetization and fast reversal times.

## SUMMARY OF THE INVENTION

The invention concerns a magnetic tunnel junction comprising a synthetic antiferromagnetic free layer (or "SyAF free layer" for short), said synthetic antiferromagnetic free layer comprising a magnetic core and a magnetic shell, the magnetic core comprising a first magnetic layer having an aspect ratio comprised between 0.5 and 2, the magnetic shell surrounding the magnetic core and at least a part of the thickness of the magnetic core, the magnetization of the magnetic shell being antiferromagnetically coupled with the magnetization of the magnetic core.

The aspect ratio is equal to the thickness of a layer divided by the width said layer (or its diameter when it is a circular layer). The thickness is measured perpendicularly to a plane which correspond to the plane of the layers (or the plane of the substrate). The width is measured parallel to said plane.

Magnetizations antiferromagnetically coupled means that said magnetizations tend to orient antiparallel.

Due to the high aspect ratio of the first magnetic layer, it exhibits a magnetization spontaneously pointing out of the plane.

The high aspect ratio also helps to rigidly couple the magnetic core and the magnetic shell. Then, due to the additional magnetic volume of the SyAF free layer, brought by the magnetic shell, there is an increase in the stability of said SyAF free layer. Thus, the thickness of the magnetic core can be reduced to achieve suitable stability values for, for example, memory or sensor requirements.

The switching reversal of the magnetic core is improved, avoiding non-coherent switching reversals, leading to faster commutation times and lower switching voltages for a specified stability.

This approach shows viable for a magnetic tunnel junction used as a storage means or as a sensor.

The antiferromagnetic coupling also provides a reduced stray field of the SyAF free layer. As the magnetic material of the magnetic shell can be chosen to reduce the total footprint of the junction, it can also offer a significant improvement to integrate narrower magnetic tunnel junctions.

Beneficially, the magnetic shell and the magnetic core are separated from each other by a non-magnetic material. It can be a dielectric and non-magnetic material, such as air, ZnO, $HfO_2$, $Al2O_3$ or TiN, or a non-magnetic material providing exchange coupling between magnetic shell and the magnetic core, such as Ru.

Beneficially, the magnetic shell surrounds exclusively the magnetic core. The magnetic shell does not surround a magnetic core belonging to another magnetic tunnel junction otherwise it would complexify the switching reversal of the magnetic core (it became a three bodies reversal mechanism) and reduce both the stability and the commutation speed. This exclusive surrounding also prevents from extending the magnetic shell along the junction. It could reach other non-free magnetic layers, such as the reference layer, which could interfere with the reversal of the SyAF free layer and also reduce the stability of said non-free magnetic layers. By non-free magnetic layer, one means a magnetic layer with a fixed orientation of its magnetization.

Beneficially, the magnetic core has a cylindrical shape extending in a direction, said "normal direction", the magnetic core having an outer surface, radially oriented with respect to the normal direction, the magnetic shell having an inner surface facing at least a part of the outer surface of the magnetic core. The inner surface of the magnetic shell and the outer surface of the magnetic core can be separated from each other by the dielectric and non-magnetic material or by the non-magnetic material providing exchange coupling.

Beneficially, the magnetic shell is centered with respect to the thickness of the magnetic core.

Beneficially, the magnetic core has a first magnetic volume and the magnetic shell has a second magnetic volume greater than 50 % of the first magnetic volume and lower than 200 % of the first magnetic volume.

Beneficially, the magnetic shell exhibits an aspect ratio $R_{shell}$, computed as

$$R_{shell} = Z_{shell} / (r_{ext} - r_{inner})$$

with $Z_{shell}$ a thickness of the magnetic shell, $r_{inner}$ an inner radius of the magnetic shell and $r_{ext}$ an external radius of the magnetic shell, the aspect ratio $R_{shell}$ of the magnetic shell being higher than 0.5.

Beneficially, the aspect ratio of the first magnetic layer is comprised between 0.7 and 1.5.

The first magnetic layer can be made of a ferromagnetic material, such as Fe, Ni, Co or an alloy thereof. The first magnetic layer can also comprise a magnetic multilayer, such as [Co/Pt]n multilayer or [FeCo(B)/MgO]n multilayer, providing uniaxial or interfacial anisotropy.

Beneficially, the magnetic core comprises a second magnetic layer, the second magnetic layer comprising a ferromagnetic material, such as Fe, the second magnetic layer lying on a tunnel barrier layer, such as an MgO layer, a perpendicular magnetic anisotropy of the second magnetic layer being induced by the interface between the second magnetic layer and the tunnel barrier layer. By tunnel barrier layer, one means a non-magnetic layer configured to allow spin transfer torque between the second magnetic layer and a non-free magnetic layer.

Beneficially, the magnetic core comprises a structural transition layer lying against the second magnetic layer and separating the first magnetic layer from the second magnetic layer, the second magnetic layer comprising an amorphising element, such as B, and the structural transition layer comprising an amorphising-getter material such as Ta, Mo, W of Hf.

An amorphising element prevents crystallization of the second magnetic layer during its deposition. During annealing the second magnetic layer crystallizes in the same structure as the tunnel barrier as the amorphising element migrates from the interface due to the amorphising getter in the transition.

Beneficially, the magnetic material of the magnetic shell has a high damping value, for example greater or equal to 0.1.

Another aspect of the invention concerns a method for producing a magnetic tunnel junction, the method comprising the following steps:

- forming a magnetic stack, the magnetic stack comprising a magnetic core, the magnetic core comprising a first magnetic layer having an aspect ratio comprised between 0.5 and 2;

- forming a SyAF free layer comprising the magnetic core and a magnetic shell by :

  - depositing a first conformal layer of a non-magnetic material on the magnetic tunnel junction, the thickness of the first conformal layer being such that the magnetization of the magnetic shell is coupled antiferromagnetically with the magnetization of the magnetic core;

- depositing a second conformal layer of a ferromagnetic material on the first conformal layer;
- etching the first and second conformal layers anisotropically until the ferromagnetic material surrounds the magnetic core and at least a part of the thickness of the magnetic core.

Another aspect of the invention concerns an array of magnetic tunnel junctions, at least one magnetic tunnel junction of the array of magnetic tunnel junctions being a magnetic tunnel junction according to the invention.

Beneficially, the magnetic tunnel junctions of the array of magnetic tunnel junctions are separated from each other by a predefined distance and by an insulator.

The invention and its various applications will be better understood with the following description and the accompanying figures.

## BRIEF DESCRIPTION OF THE FIGURES

The figures are shown for information only and are not limitative of the invention. Unless otherwise specified, the same element appearing on different figures has a unique reference.

FIG. 1A shows an example of magnetostatic energy of a free layer for several aspect ratios of a magnetic tunnel junction according to the prior art.

FIG. 1B shows a thermal stability factor for a free layer of different aspect ratios of a magnetic tunnel junction according to the prior art.

FIGS. 2A-B show examples magnetic tunnel junctions according to the prior art.

FIGS. 3A-B shows magnetic stray field lines resulting from an interfacial anisotropy layer and from a perpendicular shape anisotropy layer of a magnetic tunnel junction according to the prior art.

FIG. 4 shows decays of stray field computed for an interfacial layer and different perpendicular shape anisotropy layers of a magnetic tunnel junction according to the prior art.

FIG. 5 shows a side view of a first embodiment of a magnetic tunnel junction according to the invention.

FIG. 6A shows a cut view of a second embodiment of the magnetic tunnel junction according to the invention.

FIG. 6B shows a cut view of a third, fourth and fifth embodiments of the magnetic tunnel junction according to the invention.

FIG. 7A and FIG. 7B show two cut views of a sixth embodiment of a magnetic tunnel junction according to the invention.

FIG. 8 shows an example of an energy barrier to overcome to switch an embodiment of the magnetic tunnel junction according to the invention and the corresponding thermal stability factor against a synthetic antiferromagnetic free layer thickness of said magnetic tunnel junction.

FIG. 9A shows a time trace of the magnetization of an embodiment of the magnetic tunnel junction according to the invention, for different damping values and against a free layer according to the prior art.

FIG. 9B shows the orientation of the magnetic moment of unit cells of an embodiment of a magnetic core and a magnetic shell according to the invention, against the time.

FIGS. 10A-C show computations of the magnetic stray field of: an embodiment of a single magnetic core according to the invention; an embodiment of a single magnetic shell according to the invention; and the coupled magnetic core and magnetic shell.

FIGS. 11A-C show other computations of the magnetic stray field of embodiments of FIGS 10A-C.

FIGS. 12A-D show an array of magnetic tunnel junctions according to the prior art with different magnetic configurations.

FIGS. 13A-D show a stray field felt by one magnetic tunnel junction of the array of FIG. 12A-D and its corresponding thermal stability factor for two different diameters and thicknesses.

FIGS. 14A-D show a first embodiment of an array of magnetic tunnel junctions according to the invention with different magnetic configurations.

FIGS. 15A-B show a stray field felt by one magnetic tunnel junction of the array of FIG. 14A-D for two different diameters and thicknesses.

FIG. 16 shows a side view of a second embodiment of an array of magnetic tunnel junctions according to the invention.

FIG. 17 shows an embodiment of a method to produce an embodiment of a magnetic tunnel junction of the invention.

FIGS. 18A-I show an implementation the method of the FIG. 17.

## DETAILED DESCRIPTION

The invention concerns a magnetic tunnel junction 3 (also called "junction") providing an improved reversal mechanism and a good thermal stability. The junction 3 is intended to be used as a storage or a magnetic field probe. It also provides a side effect by reducing or even cancelling the magnetic field it emits.

The junction 3 is also relevant as it can be obtained from a magnetic junction according to a prior art, such as the one shown in FIG. 2B. Indeed, the junction 3 comprises a first magnetic free layer 321 with a large aspect ratio. The first magnetic free layer 321 is similar to the one 16b shown in FIG. 2B.

The FIG. 5 show an embodiment of a junction 3 according to the invention. The common elements with the FIG. 2B are shown using the same reference sign.

The junction 3 comprises a synthetic antiferromagnetic free layer 30, also called "SyAF free layer" for short. Said SyAF 30 comprises a magnetic core 32 (also called "core" for short) and a magnetic shell 31 (also called "shell" for short). Both the core 32 and the shell 31 are coupled in an antiferromagnetic way. In other words, the shell 31 is arranged about the core 32 to align its magnetization $m_s$ antiparallel to the magnetization $m_c$ of the core 32. In this embodiment, the shell 31 surrounds the core 32 and along the full thickness of the core 32.

The SyAF free layer 30 shows an improved reversal behaviour, compared with the isolated core 32, thanks to the shell 31. The shell 31 coupled to the core 32 improves the thermal stability of the core 32. It allows to reduce the thickness of the magnetic core 31 to improve the reversal behaviour. For example, the magnetization $m_c$ of the core 32 behave like a unique magnetic momentum (also called "macrospin") exhibiting a coherent reversal.

The core 32 comprises at least a first magnetic layer 321. This first layer 321 is remarkable as it is a thick ferromagnetic layer. It can be made of ferromagnetic material or ferromagnetic alloy based on Ni, Fe and Co, as well as others ferromagnetic materials. The thickness of the first layer 321 is such that the first layer 321 has an aspect ratio comprised between 0.5 and 2. Such aspect ratio adds a shape anisotropy perpendicular to the plane of the layers which tends to orient spontaneously the magnetization $m_s$ of the first layer 321 out of the plane of the layers. For this reason, the first layer 321 may also be called "perpendicular shape anisotropy layer" or "shape anisotropy layer" or "PSA layer". The thickness of the PSA layer 321 is preferably chosen so it has an aspect ratio that allows for a sufficiently high stability after consideration of the magnetostatic coupling with the magnetic shell 32. A high stability is greater than or equal to $\Delta \approx 80$. The aspect ratio corresponds to the thickness of said PSA layer 321, measured perpendicular to the plane of the layers, divided by its diameter (or its width), measured parallel to the plane of the layers. An aspect ratio closer to 1 would be preferred as it improves the reversal behaviour. For example, it is preferably comprised between 0.7 and 1.5.

The magnetic core 32 can also comprise a second magnetic layer 322. Said second layer 322 can be made of a ferromagnetic material such as Fe or an alloy of Fe and Co (for example CoFe or CoFeB). The second layer 322 is preferably in contact with a layer comprising O, such as MgO. The Fe-O coupling at the interface create a perpendicular magnetic anisotropy which tends to orient spontaneously the magnetization of the second layer 322 out of the plane of the layers. For this reason, the second layer 322 can also be called "perpendicular interfacial anisotropy layer" or "interfacial anisotropy layer" or "IA layer". The IA layer 322 contribute to perpendicular anisotropy of the magnetic core 32 and reinforce the out-of-plane orientation of the magnetization $m_s$ of the core 32.

The IA layer 322 is preferably thinner than the PSA layer 321 as the anisotropy only come from the interface with the O-based layer. It can exhibit a thickness comprised between 0.5 nm and 2 nm.

The magnetic core 32 can also comprise a structural transition layer 323 (also known as "B-getter layer" because it tends to trap B element from the interfacial anisotropy layer 323). The B-getter layer 323 can lie directly on the IA layer 322. It can be made of W, Ta, Mo or Hf. Such B-getter layer 323 has preferably a thickness comprised between 0.1 nm and 0.3 nm.

The PSA layer 321 can also comprise a ferromagnetic multilayer that induce a perpendicular anisotropy, such as a [Co/Pt]n multilayer (where n is the number of Co/Pt layers stacked) or a [FeCo(B)/MgO]n multilayer. For example, a [FeCo(B)/MgO]n with an aspect ratio of 0.5 exhibits a strong anisotropy as the shape anisotropy (induced by the high aspect ratio) is reinforced by the interfacial anisotropy at each FeCo(B)/MgO interfaces. The total anisotropy obtained can be equal to a unique thick layer of magnetic material, for example Fe, with an aspect ratio greater or equal to 0.9.

The IA layer 322 and the PSA layer 321 can be spaced from each other by the B-getter layer 323. Thanks to the thickness of the B-getter layer 323, the magnetization of the IA and PSA layer 322, 321 can be coupled to form a total magnetization $m_s$ which behaves as a unique magnetic momentum. Moreover, the perpendicular anisotropies brought by each layer 321, 322 tends to spontaneously orient the total magnetization out of the plane of the layers.

The material composing the B-getter layer 323 may have a coupling effect between the magnetizations of the two layers 323, 321, such as an exchange coupling. However, the magnetostatic coupling between each magnetization is sufficient.

The magnetic core 32 comprises preferably every free layer of the junction 3. More specifically, every free layer 321, 322 couple to a defined tunnel barrier 15 belongs to the same magnetic core 32. Considering a magnetic pillar comprising a plurality of magnetic tunnel junction, each magnetic core is associated with one of the tunnel barrier and comprise every magnetic free layer coupled to this tunnel barrier.

The magnetic core 32 exhibits a magnetization which is the sum of the magnetizations of the free layers 321, 322 belonging to said core 32.

The magnetic core 32 defined a volume comprising a plurality of free layers. This volume preferably also comprises the non-magnetic layers lying between these free layers 321, 322 (such as the B-getter layer 323).

To form a magnetic tunnel junction, the junction 3 may also comprise layers such as the ones shown in FIGS. 2A-B. For example, it may comprise at least a magnetic reference layer 14 separated from the core 32 by a tunnel layer 15.

The junction 3 may preferably comprise a top electrode and a bottom electrode (not shown), allowing an electrical current to flow throughout the junction, in a direction close to perpendicular to a plane of the layers.

The tunnel layer 15 is made of a non-magnetic material allowing the electrical current to cross this layer 15 in a tunnelling regime. The tunnel layer 15 is preferably made of a dielectric material such as an oxide, for example TiOx, AlOx or MgO, or a nitride layer, for example TiN. The MgO oxide is preferred as it provides the highest tunnel magnetoresistance signal. The tunnel layer 15 has usually a thickness comprised between 0.6 nm and 2 nm, preferably between 1 nm and 2 nm. It gives a resistance times area product (known as "RA product") of the junction 3 preferably lower than 10 $\Omega.\ \mu m^2$. In order to have a low RA product and a high tunnel magnetoresistance signal (known as "TMR signal"), for example higher than 80% or preferably higher than 200%, the tunnel layer 15 and the two electrodes (layers 14 and 322) should have the same crystallographic BCC structure with a (100) texture.

The reference layer 14 is a ferromagnetic layer having a fixed magnetization orientation, preferably perpendicular to the plane of the layers. The reference layer 14 can be made of an Fe, Co or alloy thereof, such as FeCo(B) alloy. The orientation of the magnetization of the reference layer 14a is kept fixed thanks to a strong perpendicular anisotropy. Such perpendicular anisotropy can be brough by the interfacial magnetic anisotropy between a Fe alloy and a MgO layer (such as the tunnel layer 15). It can also be brough by an exchange-like coupling with an out-of-plane magnetized multilayer 12 called "pinning layer". The pinning layer can comprise one or more $[Co/Pt]_n$ multilayers (however not belonging to the core 32). The $[Co/Pt]_n$ multilayers can be antiferromagnetically coupled to provide a fixed magnetization orientation.

A thin texture breaker layer can be placed between the reference layer 14 and the pinning layer 12. It allows a transition between the FCC structure of the pinning layer 12 to the BCC structure of the reference layer 14. This texture breaker layer can be made of W, Ta, Mo or Hf.

The pinning layer 12 can also reduce the stray field that the reference layer 14 exerts on the magnetic core 32.

The junction 3 can also comprise a seed layer 11, made of Ta or Pt, lying on a substrate or the bottom electrode (to allow the circulation of an electrical current) which allowed the pinning layer 12 growth. Said substrate can be made of silicon. Said bottom electrode can be made of a metallic material. The plane P of the layers is preferably considered as the plane of the substrate or the plane of the bottom electrode.

The magnetic shell 31 is also made of a ferromagnetic material. For example, it can be made of a low moment magnetic material or a high moment magnetic material, such as a Ni alloy or a Fe alloy. For example, the magnetic shell 31 is made of $Ni_{80}Fe_{20}$ which is a low moment material, which can be called "mu metal". Other example, the magnetic shell 31 is made of $Ni_{20}Fe_{80}$ which is a high moment material.

The magnetic shell 31 surrounds the magnetic core 32. In the embodiment of the FIG. 5, it exhibits a hollowed shape surrounding the cylindrical shape of the magnetic core 32. The gap can be filled by a non-magnetic material 33. It ensures that only magnetostatic interactions act on both the core 32 and the shell 31. Here the non-magnetic material 33 is air which also act as an insulator.

The gap distance between the core 32 and the shell 31 is set so the magnetizations $m_s$, $m_c$ of the shell 31 and the core 32 align antiferromagnetically to form a synthetic antiferromagnet. Aligning antiferromagnetically means that the magnetizations align spontaneously antiparallel and behave as a unique body. It means that, when the magnetization $m_c$

of the core 32 commute from one orientation, for example up, to another, for example down, the magnetization $m_s$ of shell 31 also commute from down to up.

The FIG. 6A shows a cut view of an embodiment of the SyAF free layer 30 according to the invention. In this embodiment, the magnetic core 32 shows a cylindrical shape, extending perpendicularly to the plane of the layers (parallel to the radial direction $e_R$ in a cylindrical coordinate system). In the figure, the core 32 extends along a normal direction ez, perpendicular to the plane of the layers (and thus the radial direction $e_R$). The magnetic core 32 has a height $Z_{core}$, also called "thickness", measured along the normal direction ez. Because of its cylindrical shape, the magnetic core 32 has a radius $r_{outer}$, measured along the radial direction $e_R$. The width (or diameter here) is therefore equal to $2r_{outer}$.

Due to its cylindrical shape, the magnetic core 32 has an outer surface 320, radially oriented. "Radially oriented" means that the surface is parallel to the normal direction ez. In other words, its orientation (defined by a vector perpendicular to the outer surface 320) is oriented along the radial direction $e_R$.

In this embodiment, the shell 31 exhibits a hollowed cylindrical shape, extending along the normal direction ez. It comprises a through-hole wherein the magnetic core 32 is located. The shell 31 exhibits a thickness $Z_{shell}$, measured along ez. In this embodiment, the thickness $Z_{shell}$ of the shell 31 is smaller than the thickness $Z_{core}$ of the magnetic core 31. The shell 31 and the core 32 are located at the same height, measured along the normal direction ez. In other words, the shell 31 is centered with respect to magnetic core 32, along the normal direction ez. It means that the shell 31 surrounds the outer surface 320 of the magnetic core 32 on a part of its thickness (or height). The shell 31 preferably surrounds at least a part of the thickness of the PSA layer 321 and more preferably the whole thickness of the magnetic core 32 (as shown in FIG. 5).

The magnetic shell 32 comprises an inner surface 311, in the through-hole. The inner surface 311 is also radially oriented, as the outer surface 320 of the core 32, however, its orientation (along $-e_R$) is opposed to the orientation of the outer surface 320 of the core 32. Therefore, the inner surface 311 of the shell 31 faces at least a part of the outer surface 320 of the core 32. In the embodiment of the FIG. 5, the inner surface 311 of the shell 31 faces the whole outer surface 320 of the core 32.

The shell 31 and the core 32 are coupled in a way that the magnetization $m_s$ of the shell 31 spontaneously aligns antiparallel to the magnetization $m_c$ of the magnetic core 32. To do so, the magnetic shell 31 is spaced from the magnetic core 32. Here a gap between the ferromagnetic materials ensures the magnetization $m_s$ of the shell 31 will orient antiparallel with respect to the magnetization $m_c$ of the core 32.

If, however, the magnetic shell 31 is in direct contact with the magnetic core 32, the inner surface 311 of the shell 31 being in a direct contact with the outer surface 320 of the core 32, therefore the magnetization $m_s$ of the shell 31 will tend to align parallel to the magnetization $m_c$ of the magnetic core 32. It will enhance the stray field in the vicinity of the junction 3, which may not be desired.

To prevent any magnetic coupling between the magnetizations $m_s$, $m_c$ which could align the magnetizations $m_s$, $m_c$ parallel, such as a direct coupling, a non-magnetic material 33 is located in the gap between the magnetic shell 31 and the magnetic core 32. It preferably embeds the outer surface 320 of the core 32 and the inner surface 311 of the shell 31.

For example, the non-magnetic material 33 can be an insulator such as air, vacuum. It can also be made of an oxide material such as ZnO, $HfO_2$, $Al_2O_3$ or TiN. Alternatively, the non-magnetic material 33 can be a metallic material, such as Ru, providing exchange coupling between magnetic shell 31 and the magnetic core 31. Whatever the non-magnetic material 33, the thickness $d_{gap}$ of the gap is adjusted so the coupling between the shell 31 and the core 32 is antiferromagnetic. The thickness $d_{gap}$ of the gap is, for example, comprised between 1 nm and 3 nm.

The FIG. 6B shows a top view of three embodiments of the SyAF free layer 30. In every embodiment, the magnetic core 32 is cylindrical. The first embodiment, on the left, shows a cylindrical magnetic shell 31 surrounding the magnetic core 32. It corresponds to the embodiment shown in the FIG. 6A. The second and third embodiment (in the middle and on the right of the figure) show that the magnetic shell 31 can exhibit a non-cylindrical shape. The shape is parallelepipedal with, respectively, a square base (in the middle) or a diamond base (on the right). It can also exhibit different shape such as an ellipsoidal base, with a larger size in a direction and a smaller one in the perpendicular direction.

The magnetic core 32 can also exhibits another shape such as a parallelepiped with a square base or a diamond base as well. Whatever the shape of the core 32 and the shell 31, they are spaced from each other, ensuring an antiferromagnetic coupling.

A positive side effect of the SyAF free layer 30 is to mitigate the stray field, as the antiparallel magnetizations compensate each other. To mitigate efficiently the stray field, the magnetic volume of the magnetic shell 31 should be as close as possible to the magnetic volume of the magnetic core 32. The magnetic volume of the magnetic core 32 is equal to the volume of the magnetic layers (such as the free layers) belonging to the core 32, times the magnetization saturation of each layer. The magnetic volume of the magnetic shell 31 is equal to the volume of the magnetic shell times its magnetization saturation. Considering a magnetic core 32 comprising two layers, a PSA-layer 321 made of Fe and a IA-layer 322 made of CoFe(B) and a magnetic shell 31 also made of Fe. The magnetic volume $MV_{core}$ of the magnetic core 32 is equal to

$$MV_{core} = M_{Fe} V_{PSA} + M_{CoFe(B)} V_{IA}$$

With $M_{Fe}$ and $M_{CoFe(B)}$ the magnetization saturations of Fe and CoFe(B), $V_{PSA}$ the volume of the PSA-layer, $V_{IA}$ the volume of the IA-layer 322. The magnetic volume $MV_{shell}$ of the magnetic shell 31 is equal to

$$MV_{shell} = M_{Fe} V_{shell}$$

With $V_{shell}$ the volume of the magnetic shell 31.

Following this example, the stray field is optimally mitigated when the volume of the shell is equal to the volume of the volumes of the two magnetic layers belonging to the magnetic core 32. The magnetic volume of the magnetic shell 31 are preferably at least equal to the magnetic volume of the magnetic core 32 within 20 %, and more preferably within 10 %.

Indeed, when the magnetic volume of the magnetic shell 31 is lower than 50 % of the magnetic volume of the magnetic core 32, the stray field is not entirely compensated, and the mitigation is not efficient. When the magnetic volume of the magnetic shell 31 is larger than 200 % of the magnetic volume of the magnetic core 32, the stray field of the magnetic core 32 is largely overcompensated. However, a field strayed by the junction 3 remains. This remaining field is strayed by the shell 31 instead of the core 32.

The inner radius of the shell may not be modified to fit the magnetic volume of the magnetic shell 31 to the magnetic volume of the core 32. Indeed, the antiparallel coupling between the magnetizations of the core 32 and the shell 31 is set regarding the gap distance $d_{gap}$ between each surface 320, 311 (and the non-magnetic material 33 used). Modifying this gap distance $d_{gap}$ may weaken the coupling strength, especially in a presence of a strong external field. It may also reverse the shell's magnetization 31 which would enhance the total stray field.

The magnetic volume of the shell 31 may be adjusted by modifying its thickness $Z_{shell}$ and/or its external radius $r_{ext}$.

For example, the thickness $Z_{shell}$ of the shell 31 can be extend up to the thickness of the magnetic core 32. In this configuration, the shell 31 surrounds the entire outer surface 320 of the magnetic core 32. It improves the coupling strength between the core 32 and the shell 31 as the surfaces facing each other are larger. It also improves field mitigation. Especially because the shell 31 surrounds every magnetic layer 321, 322 of the magnetic core 32.

As another example, the external radius $r_{ext}$ can be increased to increase the magnetic volume of the shell 31. Indeed, the thickness $Z_{shell}$ of the shell 31 should not be too large. It should be about the same thickness $Z_{core}$ of the core 32 (for example the same thickness $Z_{core}$) to ensure a rigid coupling between the core 32 and the shell 31. This way the reversal is optimized.

In an embodiment, the shell 31 has a thickness $Z_{shell}$ equal to the thickness $Z_{core}$ of the magnetic core 32 and the external radius $r_{ext}$ of the shell is adjusted so the magnetic volumes of the core 32 and the shell 31 matches. In this embodiment, the shell 31 looks like an hollow cylinder. In another embodiment, the shell 31 has a thickness $Z_{shell}$ much smaller than the thickness $Z_{core}$ of the magnetic core 32. However, the external radius $r_{ext}$ of the shell 31 is increased to keep the magnetic volume of the shell 31 constant. In this embodiment, the shell 31 looks like a disc surrounding the core.

The strength of the antiferromagnetic coupling between the core 32 and the shell 31 depends, among others, of the thicknesses of the core 32 and/or the shell 31 and more specifically the surfaces of the shell 31 and the core 32 facing each other. The higher the surfaces, the higher the coupling strength. The high aspect ratio of the magnetic core 32 (comprising at least the PSA-layer 321) provides a large thickness of the core 32. To ensure a high enough thickness of the shell 31, the shell's thickness $Z_{shell}$ is preferably greater or equal to 50% of the core's thickness $Z_{core}$.

In another example to ensure a high enough thickness of the shell 31, the shell 31 aspect ratio $R_{shell}$, is greater than 0.7 and preferably greater than 1. The aspect ratio $R_{shell}$ of the shell 31 is defined as :

$$R_{shell} = Z_{shell} / (r_{ext} - r_{inner})$$

Moreover, a high aspect ratio $R_{shell}$ also induces a perpendicular shape anisotropy (align along $e_Z$) to the shell 31 in a way the magnetization $m_s$ of the shell spontaneously orients out of the plane of the layers. This out-of-plane orientation may improve the core/shell coupling and the core's magnetization stability. In contrary, a low aspect ratio $R_{shell}$ induce an in-plane shape anisotropy (parallel to the plane of the layers). Therefore, the magnetization $m_s$ of the shell 31 would spontaneously orient parallel to the plane and the core's magnetization stability would be greatly reduced.

The perpendicular shape anisotropy of the magnetic shell 31 can reinforce the stability of the magnetic core 32, as their magnetizations $m_s$, $m_c$ are coupled. Therefore, the increase in stability of the magnetic core 32 can be compensated by decreasing its thickness (especially by reducing the thickness of the shape anisotropy layer), which avoid non-uniform reversal of its magnetization $m_c$. Moreover, the lateral size of the junction 3 can be further reduced, allowing for further downsize scalability.

The magnetic volume of the shell 31 may also be adjusted by modifying the magnetic material composing said shell 31. For example, the magnetic core 32 can be made of CoFeB, having a saturation magnetization of 1 MA/m, instead of Ni, which has a saturation magnetization of 0.489 MA/m. Therefore the external radius $r_{ext}$ does not need to be increased to match the magnetic volume of the core 32. In contrary, a softer material, such as Ni, can provide a better control over the magnetic volume of the shell 31 by modifying its external radius $r_{ext}$. Using a softer magnetic material, compared to Fe, also makes the magnetization switching easier as the dipolar interaction is weaker.

The FIGS. 7A and 7B show two cut views of an embodiment comprising three magnetic tunnel junctions 3 according to the invention. As the junction 3 shown in FIG. 5, the reference layers 14 are placed under the magnetic core 32 (and separated from said core 32 by the tunnel barrier 15). This arrangement is called "bottom-pinned" junctions. However, the junction of FIGS. 7A and 7B could also be lying on their caping layers 18 which would lie on the substrate 19. This upside-down arrangement is called "top-pinned" as the reference layers 14 are places on the magnetic core 32.

The FIG. 8 shows examples of energy barriers computed for a junction 1, 3 according to the prior art and according to the invention, the energy barriers being computed as a function of a dimension of the junction. The energy barrier corresponds to the energy to overcome to switch the magnetization of the core 32 from one configuration (for example up) to another configuration (for example down). The junction is considered within an array of junctions of the same kind. The barrier is shown against a reaction coordinate which is proportional to an angle of the core's magnetization with respect to a normal direction (such as the ez direction in the FIG. 6A). An illustration of the reaction coordinate is also given in the FIG. 9. For a reaction coordinate of 0, the magnetization of the core 32 is oriented in a up direction while the magnetization of the shell 31 is oriented in a down direction. For a reaction coordinate of 50, the orientation is flipped, the magnetization of the core 32 is oriented in a down direction while the magnetization of the shell 31 is oriented in a up direction. For a reaction coordinate of 25, the magnetizations of the core 32 and the shell 31 are in plane.

Six examples of energy barrier are given. The black dots show the energy barrier for junction without a magnetic shell 31. The five other examples show energy barriers of a junction 3 with a magnetic shell 31, for five different core thicknesses $Z_{core}$. A variation of the energy barrier induced a variation in the thermal stability factor $\Delta$ of the junction (which is computed thanks to the maximum energy of the barrier). The six energy barrier examples are also associated with the corresponding thermal stability factor $\Delta$.

The six energy barrier examples shown in this FIG.8 has been calculated using a finite differences 3D solver (called "micro3D") with a cubic computational cell of 1 nm. The magnetic core 32 considered is made of FeCo(B) alloy with a saturation magnetization of 1 MA/m and an exchange stiffness of 15 pJ/m. The magnetic shell 31 is considered to have magnetization oriented in an opposite direction with respect to the magnetization of the magnetic core 32. The magnetic shell 31 has a saturation magnetization of 0.489 MA/m and an exchange stiffness of 8 pJ/m. The interfacial perpendicular magnetic anisotropy is added in the simulation as a bulk anisotropy that exponentially decays as

$$K_u(z) = K_0 \exp(z/\lambda_{iPMA})$$

where $\lambda_{iPMA}$ is the decay length (usually some Angstroms). $K_0$ is calculated considering that the incremental sum of the areal value of this bulk contribution results in a macrospin surface anisotropy, taken as 1.4 mJ/m$^2$. The stability $\Delta$ of the SyAF free layer 30 with and without the contribution of the magnetic shell 31 is computed considering the defined anisotropy. This is done by computing the minimum energy that the magnetic system (and especially the SyAF free layer 30) follows to reverse the magnetization of the magnetic core 32 between two stable states (up state and down state considered in this example).

It is observed in FIG. 8 that the magnetic shell is, indeed, increasing the stability of the SyAF free layer 30. The curve with white dots shows that adding a shell 32 antiferromagnetically coupled with the magnetic core 32 improves the thermal stability factor of the SyAF free layer 30 to $\Delta$ = 129 from $\Delta$ = 86 ($\Delta$ = 86 corresponding to the single core 32).

It is then possible to reduce the total thickness $Z_{core}$ of the magnetic core 32 (and also the magnetic shell 31) while still matching thermal stability factor expected in working devices ($\Delta \approx 80$). A magnetic core 32 having a thickness $Z_{core}$ of 13 nm matches the thermal stability ($\Delta$ = 86) of a junction without shell 31 and thickness $Z_{core}$ of 16 nm. A magnetic core 32 having a thickness $Z_{core}$ of 12.5 nm matches the minimal expected thermal stability ($\Delta$ = 80).

A smaller thickness $Z_{core}$ of the core 32 improves the reversal of its magnetization as the magnetization behave as a unique giant spin (model called "macrospin") and the energy barrier to overcome is lower. Therefore, adding a shell 32 improves the reversal of the junction 3, compared to a higher core 32 without shell 31.

The FIG 9A shows calculations of the dynamics of the magnetization of the magnetic core 32 not coupled to a shell 31 (said "unshelled core") and coupled to the shell 31. The junction 3 has similar parameters as FIG. 8. The magnetic core 32 has a diameter equal to 14 nm and a thickness of 16 nm. The amplitude of voltage applied to commute the magnetization is equal to 1 V.

The calculation has been performed considering that the polarization of the spin current occurs near the interface with the tunnel barrier. An evanescent decay of the spin transfer torque pre-factor all (so called "STT pre-factor") is considered as

$$a\| = a_0 \exp z/\lambda_{STT}$$

where $\lambda_{STT}$ is the decay length along the normal direction ez and a0 is the STT pre-factor at the interface. Considering values like ones of the document [N. Caçoilo et al., "Spin-Torque-Triggered Magnetization Reversal in Magnetic Tunnel Junctions with Perpendicular Shape Anisotropy", Physical Review Applied 16, 024020 (2021)], one can obtain the temporal dependency of the magnetization under a DC voltage pulse, as shown in the FIG. 9A.

The contribution for the magnetic shell 31 and the magnetic core 32 are separated. Two different damping values of the magnetic shell are considered: a low damping regime with $\alpha_{shell} = 0.007$; and a high damping regime with $\alpha_{shell} = 0.1$. For both these situations, the reversal of the magnetic core starts 32 sooner than the unshelled core (with dots), with a faster reversal between up (+1) to down (-1) magnetization orientation. The $\alpha_{shell}$ is related to this. For a low damping regime, it is observed that the reversal of the magnetic core starts quicker, the higher the damping, the slower the initiation. In both situations, it is seen that the shell starts reversing when the magnetic core 32 is in-plane ($\langle m_z \rangle \approx 0$). In a low damping regime, the shell will take a significant amount of time to relax. However, for higher damping regime, this relaxation is faster, as the energy of the system tends to go to the ground state faster.

The FIG. 9B shows a three-dimensional snapshot of the magnetizations of the magnetic core and the magnetic shell against the time, considering a damping value of 0.1. The magnetization behaves like a macrospin, without a long relaxation time.

The FIG. 10A and 10B show an example of field strayed from the magnetic core 32 and the magnetic shell 31, each considered alone. In the same way, the FIG. 11A and 11B show the field strayed by the magnetic core 32 and the magnetic shell 31, alone. However, they also show a dashed line correspond to a 10 mT amplitude field. In this embodiment, the magnetic core 32 comprises only a PSA-layer 321 with a 20 nm diameter and 16.5 nm thickness. The magnetic shell 31 has an inner diameter of 22 nm and thickness of 16.5 nm. Both the magnetic core 32 and the magnetic shell 31 strayed a field which can reach 10 mT of more at 35 nm from the centre of the shell/core, along the X axis. The FIG. 6A shows that the field lines of the magnetic core 32 loop in a direction while the field lines of the magnetic shell 31 loop in an opposite direction.

The FIG. 10C and 11C show the effect of the magnetic shell 31 on the field strayed from itself and from the magnetic core 32. The magnetic core 32 and the magnetic shell 31 are put together and spaced by a 1 nm non-magnetic and nonconductive material 33 (such as air of vacuum). The field lines from the magnetic core 32 loop through the magnetic shell 31. The effect on the amplitude of the strayed field is shown in FIG. 11C. The amplitude is reduced. For example, the field amplitude perceived at 35 nm from the centre of the shell/core, along the direction X, is lower than 10 mT.

The FIGS. 12A to 12D show a 5x5 array of magnetic tunnel junctions 1 according to the prior art with different magnetic configurations. Said junctions do not comprise a shell and are, for this reason, named "unshelled junctions". The array of unshelled junctions is arranged following a square lattice. The diameters of the unshelled junctions 1 are 20 nm (discussed in FIGS. 13A and 13C) or 10 nm (discussed in FIGS. 13B and 13D). The different magnetic bit configurations are, respectively: A) all unshelled neighbors in an up configuration; B) all unshelled neighbors in a down configuration; C) the first nearest unshelled neighbors in a down configuration; and D) the second nearest unshelled neighbors in a up configuration. Up magnetization is shown with a black junction and down magnetization is shown with a grey junction. Only a part of each unshelled junction is shown, comprising a magnetic free layer and a tunnel barrier (in grey color at the bottom of each free layer).

The FIGS. 13A to 13D show the field felt by a central unshelled junction and its thermal stability factor, in each array configuration of FIGS. 12A to 12D. The FIGS. 13A and 13C show the normal component of the field $H_z$ felt by a central unshelled junction and its thermal stability factor, in an array of 20 nm diameter junctions 1. The FIGS. 13B and 13D show the normal component of the field $H_z$ felt by a central unshelled junction and its thermal stability factor, in an array of 10 nm diameter junctions.

The individual effect of each of the neighbouring junctions is added as a total contribution to the central unshelled junction 1. It is taken into consideration four different magnetic configuration following the FIGS. 12A to 12D. In addition to the averaged stray field in the central junction, the values of the deviation of the thermal stability factor is also given considering that the outside stray field $H_{stray}$:

$$\Delta = \Delta_0 \left(1 \pm \frac{H_{\text{stray}}}{H_k}\right)^2$$

where $\Delta_0$ is the stability factor of the central unshelled junction without external contributions, $H_{stray}$ is the averaged stray field made by the squared array and $H_k$ is the magnetic anisotropy field of the free layer of the central junction. The closer the unshelled junctions 1, the higher is the field felt and its impact on the thermal stability. When the first nearest neighbours are parallel to the magnetization of the central junction 1, the thermal stability is reduced. However, when the first nearest neighbours are antiparallel to the considered junction 1, the thermal stability is increased. The more drastic configurations are obtained when all the first and second neighbours are aligned antiparallel with respect to the central junction (FIG. 12B).

It is observed that, for a 20 nm diameter junction (following the prior art, it means without any shell 31) the stray field is very high when the junctions are in contact with each other. For a center-to-center distance 4 times the diameter of the junction, one still obtains a significant variation in stray field from the two worst configurations (FIGS. 12B and 12C). The stray field contribution is discarded for center-to-center distances higher than 10 times the diameter of the junction. For the case of a 10 nm diameter array of junction (FIGS. 13B and 13D), the decay of the stray field is slower than the decay for larger diameter junctions (FIGS. 13A and 13C).

The FIGS. 14A to 14D show a 5x5 array 4 of magnetic tunnel junctions 3 according to an embodiment of the invention. The array is arranged following a square lattice the same way as the FIGS. 12A to 12D. Each junction 3 of the array 4 comprises a SyAF free layer 30 comprising a magnetic core 32 and a magnetic shell 31. For this reason, the junctions 3 are said "shelled". The shell 31 is spaced from the core it surrounds by 1 nm. Two diameters of the magnetic cores 32 are considered: a diameter of 20 nm (discussed in FIG. 15A) of diameters of 10 nm (discussed in FIG. 15B). The same magnetic configurations are studied, respectively: A) all neighbours in a up configuration (the core's magnetization defining the orientation) ; B) all neighbours in a down configuration; C) the first nearest neighbours in a down configuration; and D) the second nearest neighbours in a up configuration. Up magnetization is shown with a black core 32 or shell 31 while the down magnetization is shown with a grey core 32 or shell 31. Each shelled junction 3 is set to exhibits an antiparallel configuration between the magnetization of the core 32 and the magnetization of the shell 31. For this reason, every shelled junction 3 shows a black shell and a grey core or a grey shell and a black core.

The FIGS. 15A and 15B compare the field felt by a central shelled junction and a central unshelled junction, in the worst configuration (every neighbour aligned antiparallel of FIGS. 12B and 14B) within the 5 x 5 array of junctions (respectively shelled and unshelled). The field felt by the shelled junction 3 (in the array 4 of FIG. 14B) is plotted using white markers while the field felt by the unshelled junction 1 (in the array of FIG. 14B) is plotted using black markers. Whatever the diameter of the junctions (FIGS. 15A or 15B), the field felt by the shelled junction 3 is smaller than the one felt by the unshelled junction, even for the smaller pitch (when the shell 31 of each junction are in contact). The inset in the FIG. 15A and 15B show, in log scale, that the decay of the field felt by the shelled junction 3 decreases faster than the field felt by the unshelled junction 1.

The FIG. 16 shows a side view of the SyAF free layers 30 of the 5 x 5 array of FIG. 14 A. Thanks to this decrease in stray field, one can increase the areal density of the array 4. It is possible to estimate a density of magnetic junctions 3 per squared millimetre following that, for a certain allowed stray field, the distance Ls between 5 different SyAF free layer 30 is given by

$$L_5 = 4 \times (2 \times r_{ext} + \delta_{sh}) + 2 \times r_{ext}$$

where $\delta_{sh}$ is the distance between to nearest shells 31.

Following the allowed stray field as a variation in the anisotropy field of each magnetic core 32 (without consideration for SyAF free layer 30). Knowing that the anisotropy field $H_K$ for a 20 nm diameter and 16.5 nm thick magnetic core is about 129 mT and allowing variations of 2% and 1 % of the stability factor $\Delta$ (corresponding to an increase/reduce of the anisotropy field), one can determine the density of the Table 1:

Table 1

| | $H_K$ (mT) | Variation of 2 % (mT) | Pitch (nm) | Density (Gbit/mm$^2$) | Variation of 1% (mT) | Pitch (nm) | Density (Gbit/mm$^2$) |
|---|---|---|---|---|---|---|---|
| Array of unshelled junctions | 129 | 2.6 | 111 | 2.8 | 1.3 | 140 | 2.2 |
| Array of shelled junctions | 129 | 2.6 | 53 | 3.3 | 1.3 | 60 | 2.9 |

The same applies for a 10 nm diameter and 20 nm thick magnetic core which exhibits an anisotropy field $H_K$ about 426 mT. One can then determine the density of the Table 2:

Table 2

| | $H_K$ (mT) | Variation of 2 % (mT) | Pitch (nm) | Density ($Gbit/mm^2$) | Variation of 1% (mT) | Pitch (nm) | Density ($Gbit/mm^2$) |
|---|---|---|---|---|---|---|---|
| Array of unshelled junctions | 426 | 8.5 | 49 | 12.7 | 4.3 | 62 | 10 |
| Array of shelled junctions | 426 | 8.5 | 21 | 16 | 4.3 | 26 | 13 |

It is observed a substantial increase in the areal density (in $Gbit/mm^2$) when the junctions are shelled. The highest density is obtained using 10 nm diameter shelled junctions. It should be also considered that the increase in the anisotropy field $H_K$ due to the interaction with the magnetic shell is not considered. This interaction would increase the anisotropy field $H_K$, allowing for a smaller pitch between the junctions and therefore a higher density. The calculation of an optimal value of the external radius of the magnetic shell 31 for a predetermined pitch value may be given by:

$$r_{\text{ext}} = \min( |H_Z(\text{core}) + H_Z(r_{\text{inner}}) - H_Z(r_{\text{ext}})| )$$

where $H_Z(r)$ is the field, along the normal direction ez, felt at the coordinate r.

The SyAF free layer 30 can be dimensioned to reduce the stray field at the certain position instead of providing a global reduction in every direction, even if it increases the stray field at another position.

FIGS. 17 shows an embodiment of a method 5 to produce a magnetic tunnel junction 3 following the invention. An example of process flow to produce the junction 3 is shown in FIGS. 18A to 18I. Certain elements commonly used for the usual CMOS integration are not shown for simplicity.

Firstly, the method 5 comprises a step of forming 51 a magnetic stack, which can be usual magnetic tunnel junction according to the prior art. The formation 51 step comprises, for example, the sub-step of depositing 511 multiple layers material on an electrode 5111. Said stack of layers comprising, from the electrode 5111, a first layer 5112 of a magnetic material intended to form a reference layer 14, a second layer 5113 of a dielectric material, intended to form a tunnel barrier 15 and at least a third layer 5114 of a magnetic material, intended to form the magnetic core 32, it means at least the PSA-layer as discussed previously.

A magnetic tunnel junction may comprise different crystallographic structures: BCC (body centered cubic) close to the tunnel barrier 15 and (face centered cubic) in the bottom and top part of the junction. The stack of layers is preferably deposited in a way that the reference layer 14 exhibits a BCC structure. Additional layers, intended to form a synthetic antiferromagnet, can be deposited to exhibit a FCC structure. A thin texture breaker layer can be added between these layers to allow the growth of the reference layer following a BCC structure.

The resistance × area product (known as RA product) of the junction to produce should be smaller than 10 $\Omega.\mu m^2$ to achieve high TMR signal (above 80%, even though it is preferable above 200%). To do so, the tunnel barrier 15 and the two magnetic layers 5112, 5114 (intended to form the reference layer 14 and the magnetic core 32) should have the same BCC structure with a (100) texture. This can be achieved by using a metallic alloy : which comprises an amorphising element such as B; and which crystallizes in the same structure as the material of the tunnel barrier, such as MgO. FeCo(B) alloy can be a good candidate. The crystallization can be performed upon annealing at a temperature usually ranging from 250 °C to 400 °C. To help the crystallization, the B element (or any amorphising element present in the alloy), should be removed from the vicinity of the tunnel barrier. Thus, a thin layer, composed of a material which can act as a amorphising-getter (usually named as "B-getter"), is deposited adjacent to each FeCo(B) alloy layer, opposite to the interface with the tunnel barrier 15. Such amorphising-getter can be made of W, Ta, Mo or Hf.

The deposition sub-step 511 can also comprise a deposition of a metallic layer on top of the upper free layer 5114 (or the B-getter if applicable) and its etching to a form metallic hard-mask 5115. The etching can be done by electron beam etching.

A sub-step of vertical etching 512 is then performed through the metallic hard-mask 5115 to etch the previously deposited layers 5112, 5113, 5114 and form a magnetic junction under the hard-mask 5115. The surface of the junction, measured parallel to the plane of the layers, is preferably chosen to allow the magnetization of the magnetic core 32 to spontaneously points out of the plane of the layers. The etching of the third layer 5114 of a magnetic material is, for example, performed to form a PSA-layer 321 having an aspect ratio comprised between 0.5 and 2.

Afterwards, the magnetic stacks are encapsulated 513 in a first dielectric material 5130. The first dielectric material 5115 is then etched 514 down to the bottom of the third layer 5114 and preferably to the bottom of the magnetic core 32. This etching 514 can be done by reactive ion-etching or physical ion-etching. This etching 514 defines the lower limit of the magnetic shell 31 and also breaks the magnetic contact between adjacent junctions.

The method 5 then comprises a step of forming 52 the SyAF free layer 30. It comprises the formation of a magnetic shell 31 surrounding the magnetic core 32 located under the hard-mask 5115. First, it comprises a sub-step of depositing 521 a first conformal layer 5210 of a non-magnetic material 33 on the previously formed magnetic stacks. Said material 33 is, for example, a second dielectric material such as ZnO, $HfO_2$, $Al_2O_3$ and TiN. The thickness of the first conformal layer 5210 is set to allow the magnetization of the magnetic shell 31 (which is formed later) to align antiparallel with the magnetization of the magnetic core 32 located under the hard-mask 5115. The thickness of the first conformal layer 5210 is comprises between 0.3 nm to 5 nm, and preferably from 0.5 nm to 2 nm, for example equal to 1 nm. The thickness of the first conformal layer 5210 should not be reduced below a certain threshold thickness because it will cause the magnetization of the magnetic shell 31 to spontaneously align parallel with respect to the magnetization of the magnetic core. The first conformal layer can be deposited 521 using conformal deposition techniques, such as atomic layer-deposition.

The method 5 then comprises then comprises a sub-step of depositing 522 a second conformal layer 5220 of a magnetic material on the first conformal layer 5210. Said magnetic material can be a Fe or Ni alloy. The second conformal layer 5220 can also be deposited 522 using conformal deposition techniques, such as atomic layer-deposition.

The external radius for the second conformal layer 5220, measured parallel to the plane of the layers, depends on the saturation magnetisation of the materials of the magnetic core 32 and the second conformal layer 5220, as discussed before, and defines the outer radius of the SyAF free layer 30.

A sub-step of etching 523 the first and second conformal layers 5210, 5220 is performed until the magnetic material of the second conformal layer 5220 surrounds the magnetic core 32. This etching 523 is preferably performed to expose the metallic hard-mask 5115 to define a superior limit of the resulting magnetic shell 31. However, the etching is stopped such that magnetic shell 31 surrounds at least a part of the thickness (measured perpendicular to the plane of the layers) of the magnetic core 32. The etching can be done resorting ion beam-etching.

The subs-step of etching 523 the first and second conformal layers is preferably performed to the magnetic shells 31 of adjacent junctions 3. It is performed until there is no magnetic material in between said adjacent junctions 3. This way, the reversal mechanism of the SyAF free layer 30 belonging to different junctions 3 behave as a unique magnetization. Magnetic material in between two adjacent SyAF free layers 30 could complexify the reversal mechanism, reduce the thermal stability and increase the commutation time.

Afterwards, a second encapsulation 524 can be performed and a consequent thinning 525 is done to expose the metallic hard-mask 5115. The structure described above can be adapted as "bottom pinned" junction (the reference layer being located at the bottom side of the finale junction) or as a "top pinned" junction (the reference layer being located at the top of the finale junction). It may be expected from the deposition and etching sub-steps that the edges of the junction are not perfectly verticals. An angle, between +/-20° or less (for example +/- 10°) is acceptable and the magnetic shell can behave as expected.

## Claims

1. Magnetic tunnel junction (3) comprising a synthetic antiferromagnetic free layer (30), **characterised in that** said synthetic antiferromagnetic free layer (30) comprises a magnetic core (32) and a magnetic shell (31), the magnetic core comprising a first magnetic layer (321) having an aspect ratio comprised between 0.5 and 2, the magnetic shell surrounding the magnetic core and at least a part of the thickness ($Z_{core}$) of the magnetic core, the magnetization ($m_s$) of the magnetic shell being antiferromagnetically coupled with the magnetization ($m_c$) of the magnetic core.

2. Magnetic tunnel junction (3) according to the previous claim, wherein the magnetic shell (31) and the magnetic core (32) are separated from each other by a non-magnetic material (33), said non-magnetic material being a dielectric and non-magnetic material, such as air, ZnO, $HfO_2$, $Al2O_3$ or TiN, or a non-magnetic material providing exchange coupling between magnetic shell and the magnetic core, such as Ru.

3. Magnetic tunnel junction (3) according to any of the previous claims, wherein the magnetic shell (31) surrounds exclusively the magnetic core (32).

4. Magnetic tunnel junction (3) according to any of the previous claims, wherein the magnetic shell (31) is centered with respect to the thickness ($Z_{core}$) of the magnetic core (32).

5. Magnetic tunnel junction (3) according to any of the previous claims, wherein the magnetic core (32) has a first magnetic volume and the magnetic shell (31) has a second magnetic volume greater than 50 % of the first magnetic volume and lower than 200 % of the first magnetic volume.

6. Magnetic tunnel junction (3) according to any of the previous claims, wherein the magnetic shell (32) exhibits an aspect ratio $R_{shell}$, computed as

$$R_{shell} = Z_{shell} / (r_{ext} - r_{inner})$$

with $Z_{shell}$ a thickness of the magnetic shell (31), $r_{inner}$ an inner radius of the magnetic shell (31) and $r_{ext}$ an external radius of the magnetic shell (31), the aspect ratio $R_{shell}$ of the magnetic shell (31) being higher than 0.5.

**7.** Magnetic tunnel junction (3) according to any of the previous claims, wherein the magnetic core (32) comprises a second magnetic layer (322), the second magnetic layer comprising a magnetic material, such as Fe, the second magnetic layer lying on a tunnel barrier layer (15), such as an MgO layer, a perpendicular magnetic anisotropy of the second magnetic layer being induced by the interface between the second magnetic layer and the tunnel barrier layer.

**8.** Magnetic tunnel junction (3) according to the previous claim, wherein the magnetic core (32) comprises a structural transition layer (323) lying against the second magnetic layer (322) and separating the first magnetic layer (321) from the second magnetic layer, the second magnetic layer comprising an amorphising element, such as B, and the structural transition layer comprising an amorphising-getter material such as Ta, Mo, W of Hf.

**9.** Magnetic tunnel junction (3) according to any of the previous claims, wherein the magnetic material of the magnetic shell (31) has a high damping value.

**10.** Array (4) of magnetic tunnel junctions (1, 3), at least one magnetic tunnel junction (3) of the array of magnetic tunnel junctions (1, 3) being a magnetic tunnel junction (3) according to any of the previous claims.

**11.** Method (5) for producing a magnetic tunnel junction (3), the method comprising the following steps :

- forming (51) a magnetic stack, the magnetic stack comprising a magnetic core (32) comprising a first magnetic layer (321) having an aspect ratio comprised between 0.5 and 2;
- forming (52) a synthetic antiferromagnetic free layer (30) comprising the magnetic core and a magnetic shell (31) by :
    - depositing (521) a first conformal layer (5210) of a non-magnetic material on the magnetic stack, the thickness of the first conformal layer being such that the magnetization of the magnetic shell is coupled antiferromagnetically with the magnetization of the magnetic core;
    - depositing (522) a second conformal layer (5220) of a magnetic material on the first conformal layer;
    - etching (523) the first and second conformal layers anisotropically until the magnetic material surrounds the magnetic core and at least a part of the thickness of the magnetic core.

**Patentansprüche**

**1.** Magnetischer Tunnelübergang (3) mit einer synthetischen antiferromagnetischen freien Schicht (30), **dadurch gekennzeichnet, dass**
die synthetische antiferromagnetische freie Schicht (30) einen Magnetkern (32) und eine Magnetschale (31) umfasst, wobei der Magnetkern eine erste Magnetschicht (321) mit einem Seitenverhältnis zwischen 0,5 und 2 umfasst, die Magnetschale den Magnetkern und mindestens einen Teil der Dicke ($Z_{core}$) des Magnetkerns umgibt, wobei die Magnetisierung ($m_s$) der Magnetschale antiferromagnetisch mit der Magnetisierung ($m_{c)}$ des Magnetkerns gekoppelt ist.

**2.** Magnetischer Tunnelübergang (3) nach dem vorhergehenden Anspruch, bei dem die Magnetschale (31) und der Magnetkern (32) durch ein nichtmagnetisches Material (33) voneinander getrennt sind, wobei das nichtmagnetische Material ein dielektrisches und nichtmagnetisches Material ist, wie Luft, ZnO, $HfO_2$, $Al_2$ $O_3$ oder TiN, oder ein nichtmagnetisches Material, das eine Austauschkopplung zwischen einer Magnetschale und dem Magnetkern sicherstellt, wie Ru.

**3.** Magnetischer Tunnelübergang (3) nach einem der vorhergehenden Ansprüche, bei dem die Magnetschale (31) ausschließlich den Magnetkern (32) umgibt.

**4.** Magnetischer Tunnelübergang (3) nach einem der vorhergehenden Ansprüche, bei dem die Magnetschale (31) in Bezug auf die Dicke ($Z_{core}$) des Magnetkerns (32) zentriert ist.

**5.** Magnetischer Tunnelübergang (3) nach einem der vorhergehenden Ansprüche, bei dem der Magnetkern (32) ein erstes magnetisches Volumen und die Magnetschale (31) ein zweites magnetisches Volumen aufweist, das größer als 50 % des ersten magnetischen Volumens und kleiner als 200 % des ersten magnetischen Volumens ist.

**6.** Magnetischer Tunnelübergang (3) nach einem der vorhergehenden Ansprüche, bei dem die Magnetschale (32) ein Seitenverhältnis $R_{shell}$, das wie folgt berechnet wird, aufweist

$$R_{shell} = Z_{shell} / (r_{ext} - r_{inner})$$

wobei $Z_{shell}$ eine Dicke der Magnetschale (31), $r_{inner}$ ein Innenradius der Magnetschale (31) und $r_{ext}$ ein Außenradius der Magnetschale (31) ist, wobei das Seitenverhältnis $R_{shell}$ der Magnetschale (31) größer als 0,5 ist.

**7.** Magnetischer Tunnelübergang (3) nach einem der vorhergehenden Ansprüche, bei dem der Magnetkern (32) eine zweite Magnetschicht (322) umfasst, wobei die zweite Magnetschicht ein magnetisches Material, wie Fe, umfasst und die zweite Magnetschicht auf einer Tunnelbarriereschicht (15), wie einer MgO-Schicht, ruht, wobei eine senkrechte magnetische Anisotropie der zweiten Magnetschicht durch die Grenzfläche zwischen der zweiten Magnetschicht und der Tunnelbarriereschicht induziert wird.

**8.** Magnetischer Tunnelübergang (3) nach dem vorhergehenden Anspruch, bei dem der Magnetkern (32) eine strukturelle Übergangsschicht (323) umfasst, die an der zweiten Magnetschicht (322) anliegt und die erste Magnetschicht (321) von der zweiten Magnetschicht trennt, wobei die zweite Magnetschicht ein amorphisierendes Element, wie B, umfasst und die strukturelle Übergangsschicht ein amorphisierendes Gettermaterial, wie Ta, Mo, W oder Hf, umfasst.

**9.** Magnetischer Tunnelübergang (3) nach einem der vorhergehenden Ansprüche, bei dem das magnetische Material der Magnetschale (31) einen hohen Dämpfungswert aufweist.

**10.** Array (4) von magnetischen Tunnelübergängen (1, 3), bei dem mindestens ein magnetischer Tunnelübergang (3) des Arrays von magnetischen Tunnelübergängen (1, 3) ein magnetischer Tunnelübergang (3) nach einem der vorhergehenden Ansprüche ist.

**11.** Verfahren (5) zur Herstellung eines magnetischen Tunnelübergangs (3), wobei das Verfahren die folgenden Schritte umfasst:

- Bildung (51) eines magnetischen Stapels, wobei der magnetische Stapel einen Magnetkern (32) umfasst, der eine erste magnetische Schicht (321) mit einem Seitenverhältnis zwischen 0,5 und 2 umfasst;
- Bildung (52) einer synthetischen antiferromagnetischen freien Schicht (30), die den Magnetkern und eine Magnetschale (31) umfasst, durch:
  - ◦ Aufbringen (521) einer ersten konformen Schicht (5210) aus einem nichtmagnetischen Material auf den Magnetstapel, wobei die Dicke der ersten konformen Schicht so ist, dass die Magnetisierung der Magnetschale antiferromagnetisch mit der Magnetisierung des Magnetkerns gekoppelt ist;
  - ◦ Aufbringen (522) einer zweiten konformen Schicht (5220) aus einem magnetischen Material auf die erste konforme Schicht;
  - ◦ Ätzen (523) der ersten und zweiten konformen Schicht auf anisotrope Weise, bis das magnetische Material den Magnetkern und mindestens einen Teil der Dicke des Magnetkerns umgibt.

## Revendications

**1.** Jonction à effet tunnel magnétique (3) comprenant une couche libre antiferromagnétique synthétique (30), **caractérisée en ce que**
ladite couche libre antiferromagnétique synthétique (30) comprend un noyau magnétique (32) et une coquille magnétique (31), le noyau magnétique comprenant une première couche magnétique (321) ayant un rapport d'aspect compris entre 0,5 et 2, la coquille magnétique entourant le noyau magnétique et au moins une partie de l'épaisseur ($Z_{core}$) du noyau magnétique, la magnétisation ($m_s$) de la coquille magnétique étant antiferromagnétiquement couplée avec la magnétisation ($m_c$) du noyau magnétique.

**2.** Jonction à effet tunnel magnétique (3) selon la revendication précédente, dans laquelle la coquille magnétique (31) et le noyau magnétique (32) sont séparés l'un de l'autre par un matériau amagnétique (33), ledit matériau amagnétique étant un matériau diélectrique et amagnétique, tel que l'air, ZnO, $HfO_2$, $Al_2O_3$ ou TiN, ou un matériau amagnétique assurant un couplage d'échange entre la coquille magnétique et le noyau magnétique, tel que le Ru.

**3.** Jonction à effet tunnel magnétique (3) selon l'une quelconque des revendications précédentes, dans laquelle la coquille magnétique (31) entoure exclusivement le noyau magnétique (32).

**4.** Jonction à effet tunnel magnétique (3) selon l'une quelconque des revendications précédentes, dans laquelle la coquille magnétique (31) est centrée par rapport à l'épaisseur ($Z_{core}$) du noyau magnétique (32).

**5.** Jonction à effet tunnel magnétique (3) selon l'une quelconque des revendications précédentes, dans laquelle le noyau magnétique (32) a un premier volume magnétique et la coquille magnétique (31) a un deuxième volume magnétique supérieur à 50 % du premier volume magnétique et inférieur à 200 % du premier volume magnétique.

**6.** Jonction à effet tunnel magnétique (3) selon l'une quelconque des revendications précédentes, dans laquelle la coquille magnétique (32) présente un rapport d'aspect $R_{shell}$, calculé comme suit

$$R_{shell} = Z_{shell} /(r_{ext} - r_{inner})$$

$Z_{shell}$ étant une épaisseur de la coquille magnétique (31), $r_{inner}$ un rayon interne de la coquille magnétique (31) et $r_{ext}$ un rayon externe de la coquille magnétique (31), le rapport d'aspect $R_{shell}$ de la coquille magnétique (31) étant supérieur à 0,5.

**7.** Jonction à effet tunnel magnétique (3) selon l'une quelconque des revendications précédentes, dans laquelle le noyau magnétique (32) comprend une deuxième couche magnétique (322), la deuxième couche magnétique comprenant un matériau magnétique, tel que Fe, la deuxième couche magnétique reposant sur une couche barrière tunnel (15), telle qu'une couche MgO, une anisotropie magnétique perpendiculaire de la deuxième couche magnétique étant induite par l'interface entre la deuxième couche magnétique et la couche barrière tunnel.

**8.** Jonction à effet tunnel magnétique (3) selon la revendication précédente, dans laquelle le noyau magnétique (32) comprend une couche de transition structurelle (323) reposant contre la deuxième couche magnétique (322) et séparant la première couche magnétique (321) de la deuxième couche magnétique, la deuxième couche magnétique comprenant un élément amorphisant, tel que B, et la couche de transition structurelle comprenant un matériau getter amorphisant tel que Ta, Mo, W ou Hf.

**9.** Jonction à effet tunnel magnétique (3) selon l'une quelconque des revendications précédentes, dans laquelle le matériau magnétique de la coquille magnétique (31) a une valeur d'amortissement élevée.

**10.** Matrice (4) de jonctions à effet tunnel magnétiques (1, 3), au moins une jonction à effet tunnel magnétique (3) de la matrice de jonctions tunnel magnétiques (1, 3) étant une jonction à effet tunnel magnétique (3) selon l'une quelconque des revendications précédentes.

**11.** Procédé (5) de production d'une jonction à effet tunnel magnétique (3), le procédé comprenant les étapes suivantes :

- formation (51) d'un empilement magnétique, l'empilement magnétique comprenant un noyau magnétique (32) comprenant une première couche magnétique (321) ayant un rapport d'aspect compris entre 0,5 et 2 ;
- formation (52) d'une couche libre antiferromagnétique synthétique (30) comprenant le noyau magnétique et une coquille magnétique (31) en :
    - ◦ déposant (521) une première couche conforme (5210) d'un matériau amagnétique sur l'empilement magnétique, l'épaisseur de la première couche conforme étant telle que la magnétisation de la coquille magnétique est antiferromagnétiquement couplée avec la magnétisation du noyau magnétique ;
    - ◦ déposant (522) une deuxième couche conforme (5220) d'un matériau magnétique sur la première couche conforme ;
    - ◦ gravant (523) les première et deuxième couches conformes de manière anisotrope jusqu'à ce que le matériau magnétique entoure le noyau magnétique et au moins une partie de l'épaisseur du noyau

magnétique.

FIG. 1A

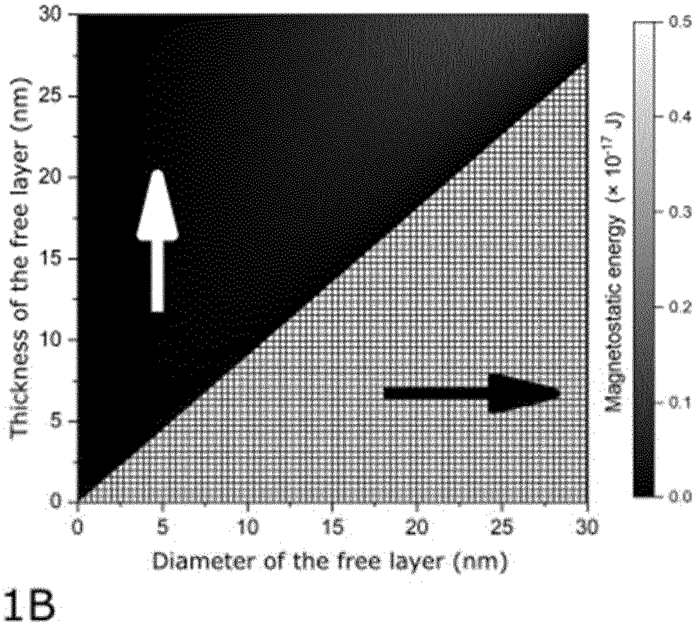
Thickness of the free layer (nm)
Diameter of the free layer (nm)
Magnetostatic energy (× $10^{-17}$ J)
0.0
0.1
0.2
0.3
0.4
0.5
0
5
10
15
20
25
30

FIG. 1B

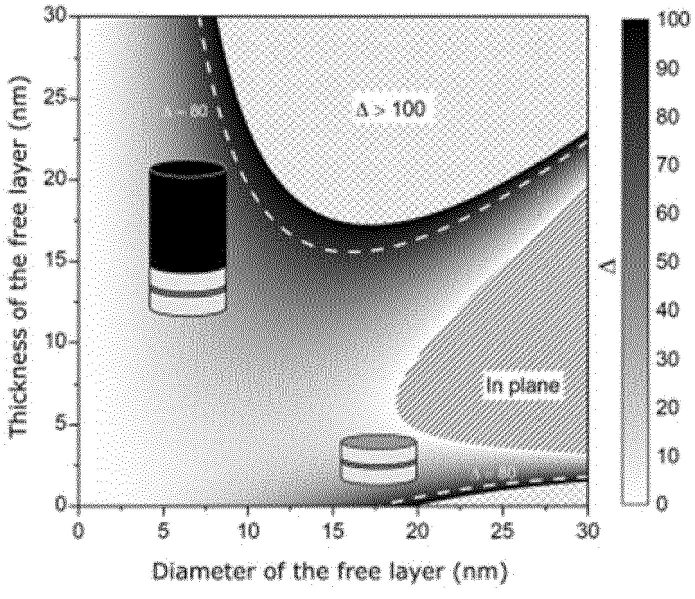
Thickness of the free layer (nm)
Diameter of the free layer (nm)
Δ > 100
In plane
Δ
0
10
20
30
40
50
60
70
80
90
100

FIG. 2A

FIG. 2B

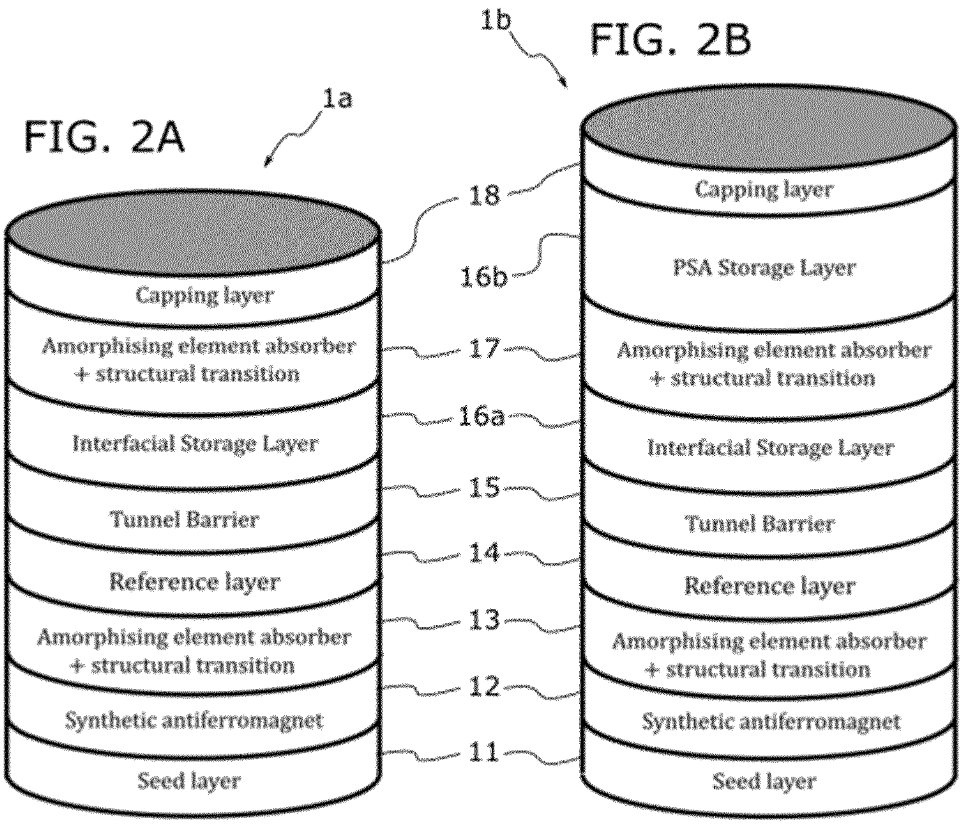
1a
1b
18
16b
17
16a
15
14
13
12
11
Capping layer
Amorphising element absorber
+ structural transition
Interfacial Storage Layer
Tunnel Barrier
Reference layer
Amorphising element absorber
+ structural transition
Synthetic antiferromagnet
Seed layer
Capping layer
PSA Storage Layer
Amorphising element absorber
+ structural transition
Interfacial Storage Layer
Tunnel Barrier
Reference layer
Amorphising element absorber
+ structural transition
Synthetic antiferromagnet
Seed layer

FIG. 3A

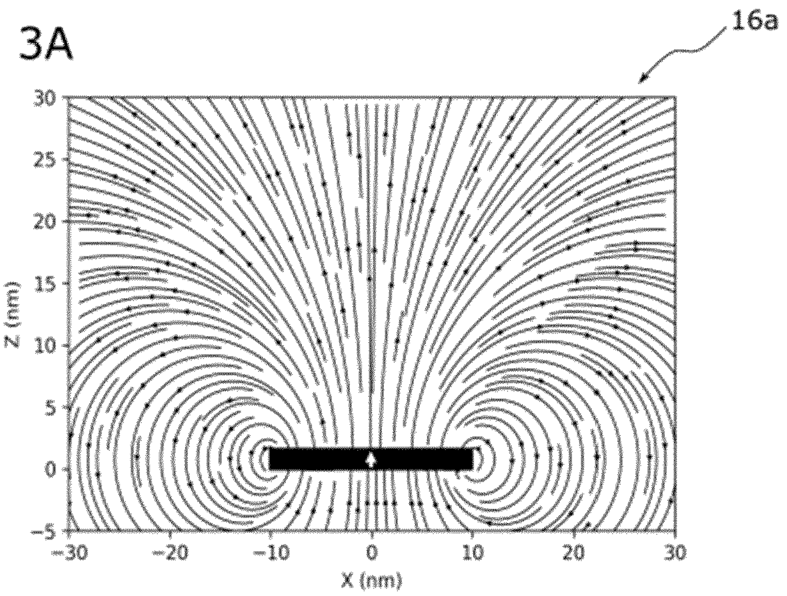
16a
30
25
20
15
10
5
0
−5
Z (nm)
−30
−20
−10
0
10
20
30
X (nm)

FIG. 3B

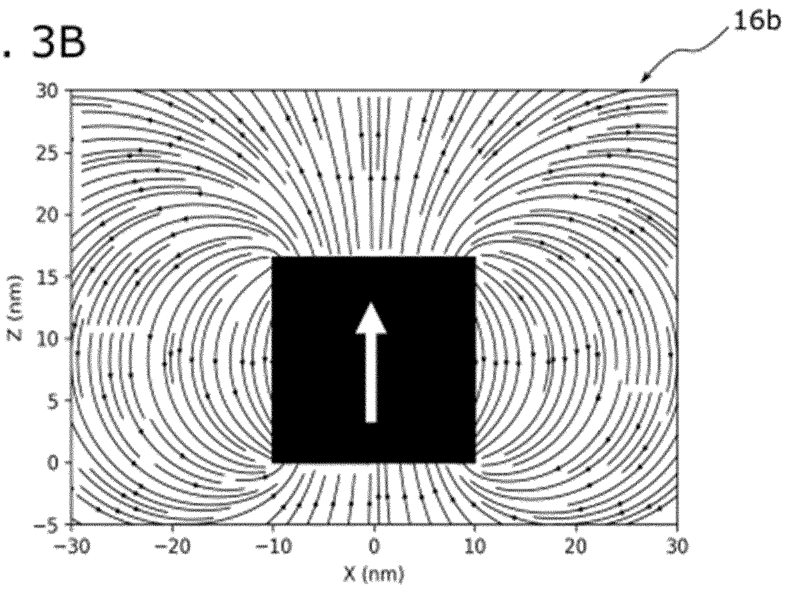
16b
30
25
20
15
10
5
0
−5
Z (nm)
−30
−20
−10
0
10
20
30
X (nm)

FIG. 4

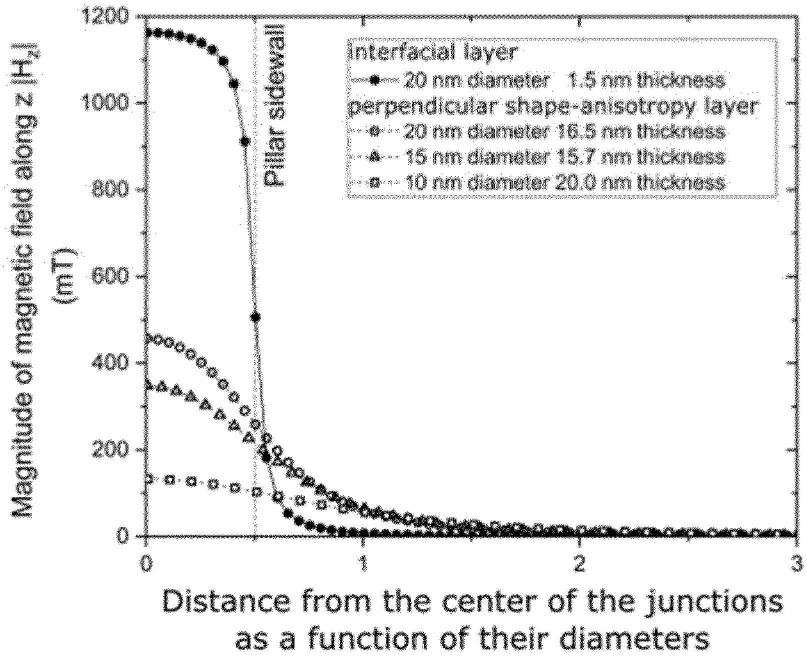
1200
1000
800
600
400
200
0
Magnitude of magnetic field along z $|H_z|$ (mT)
Pillar sidewall
interfacial layer
20 nm diameter 1.5 nm thickness
perpendicular shape-anisotropy layer
20 nm diameter 16.5 nm thickness
15 nm diameter 15.7 nm thickness
10 nm diameter 20.0 nm thickness
0
1
2
3
Distance from the center of the junctions as a function of their diameters

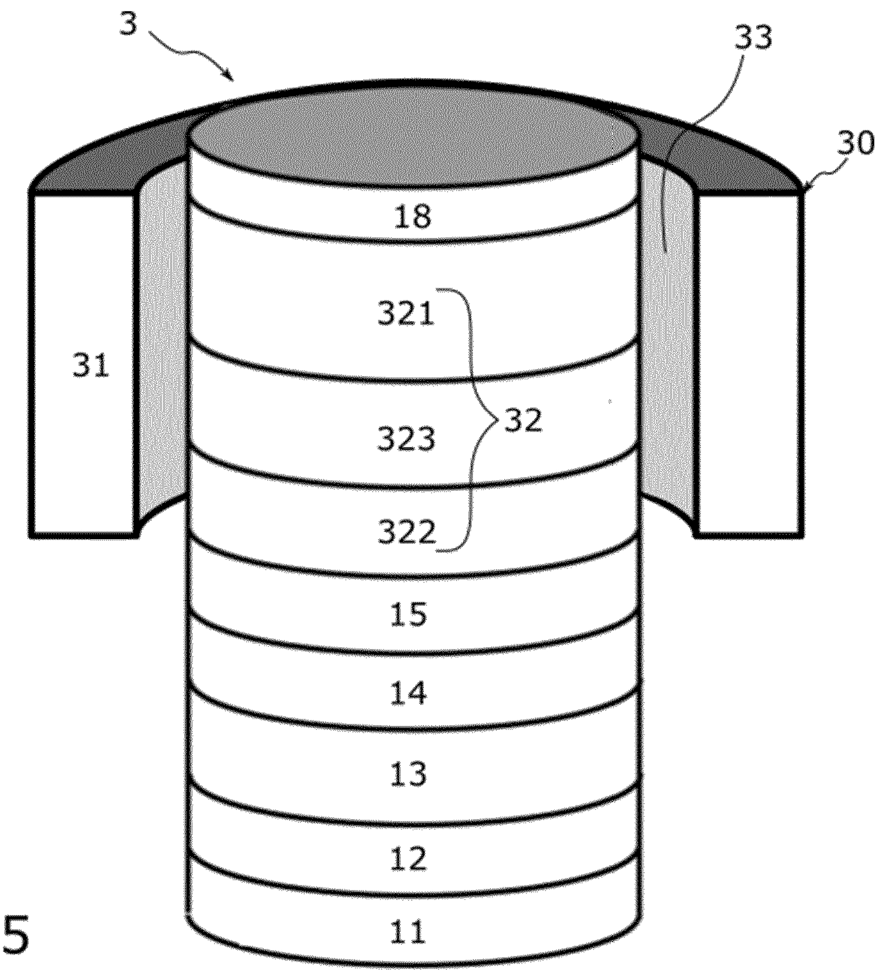
3
33
30
18
321
31
323
32
322
15
14
13
12
11

FIG. 5

FIG. 6A

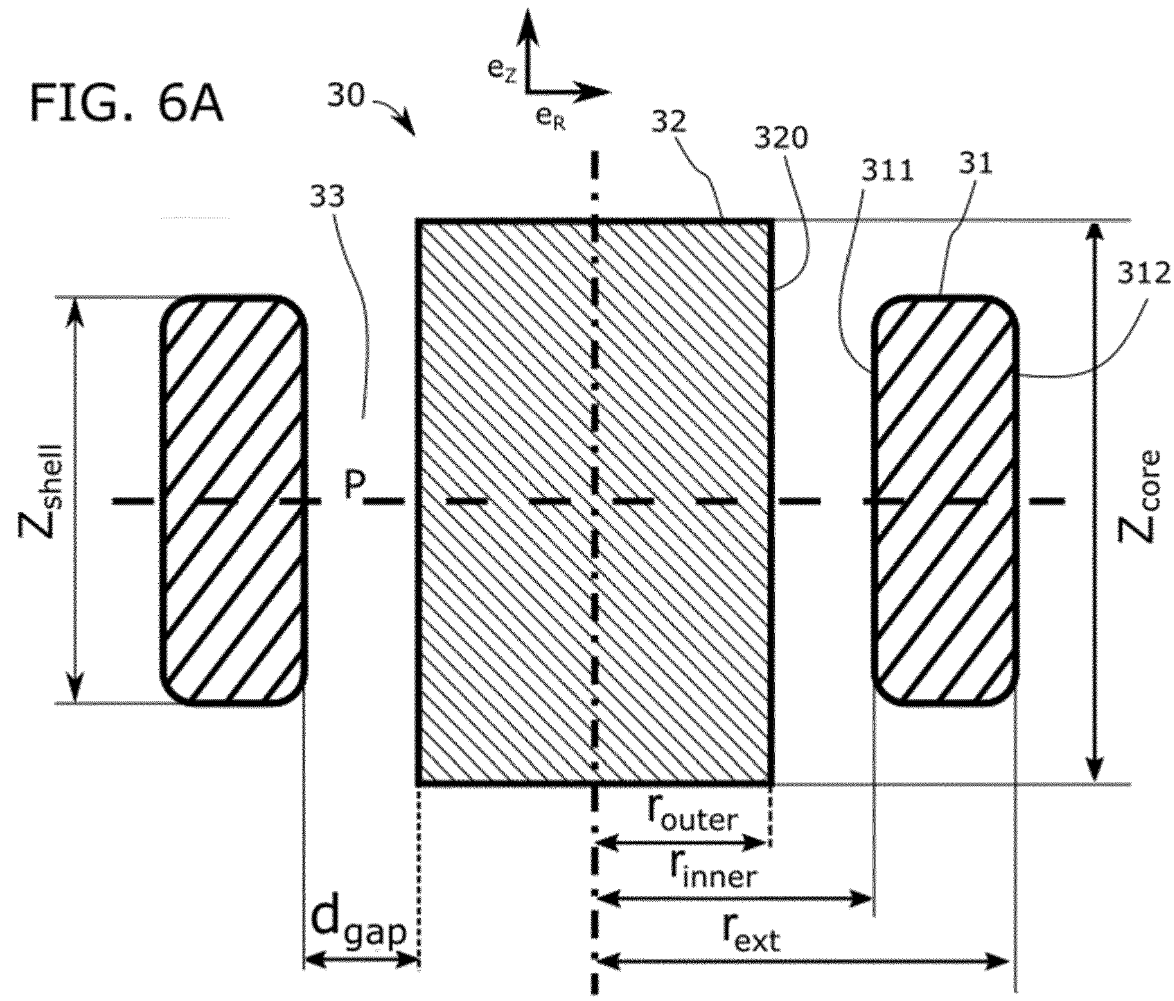
30
$e_Z$
$e_R$
32
320
311
31
33
312
P
$Z_{shell}$
$Z_{core}$
$r_{outer}$
$r_{inner}$
$r_{ext}$
$d_{gap}$

FIG. 6B

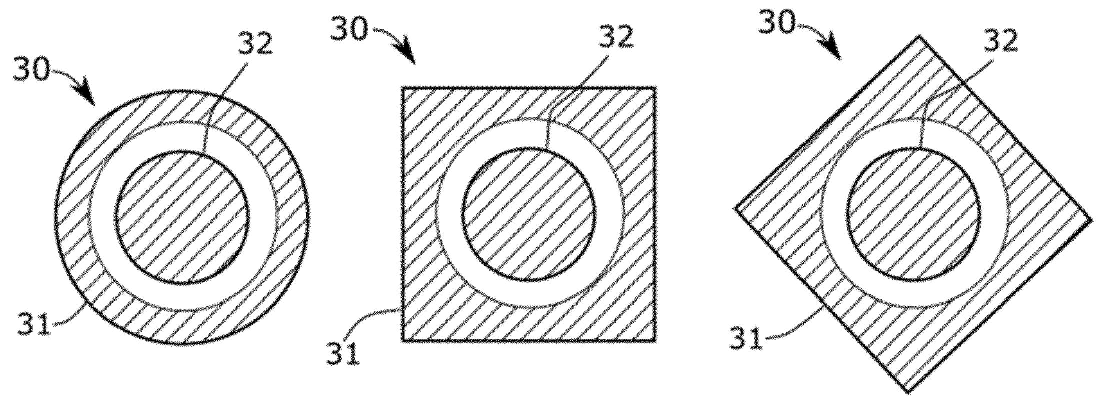
30
32
31
30
32
31
30
32
31

FIG. 7A

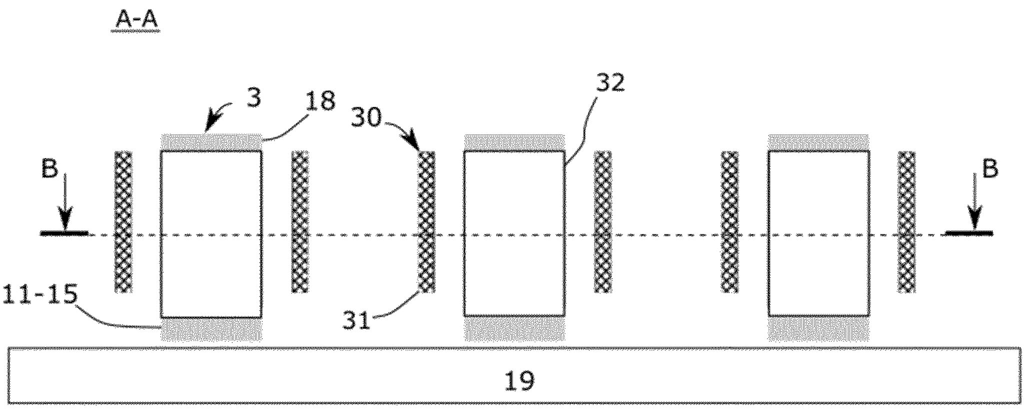


FIG. 7B

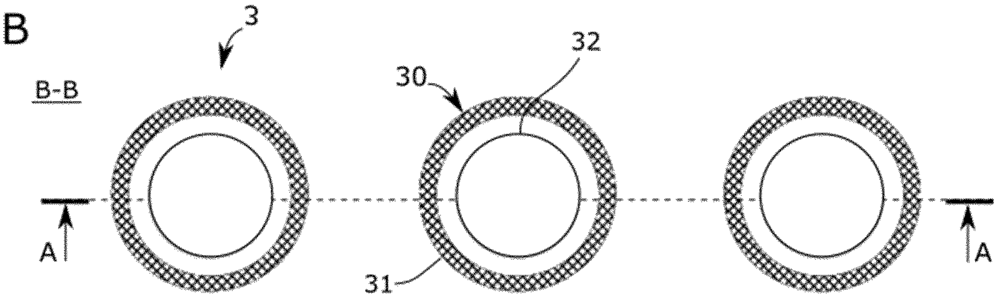

FIG. 8

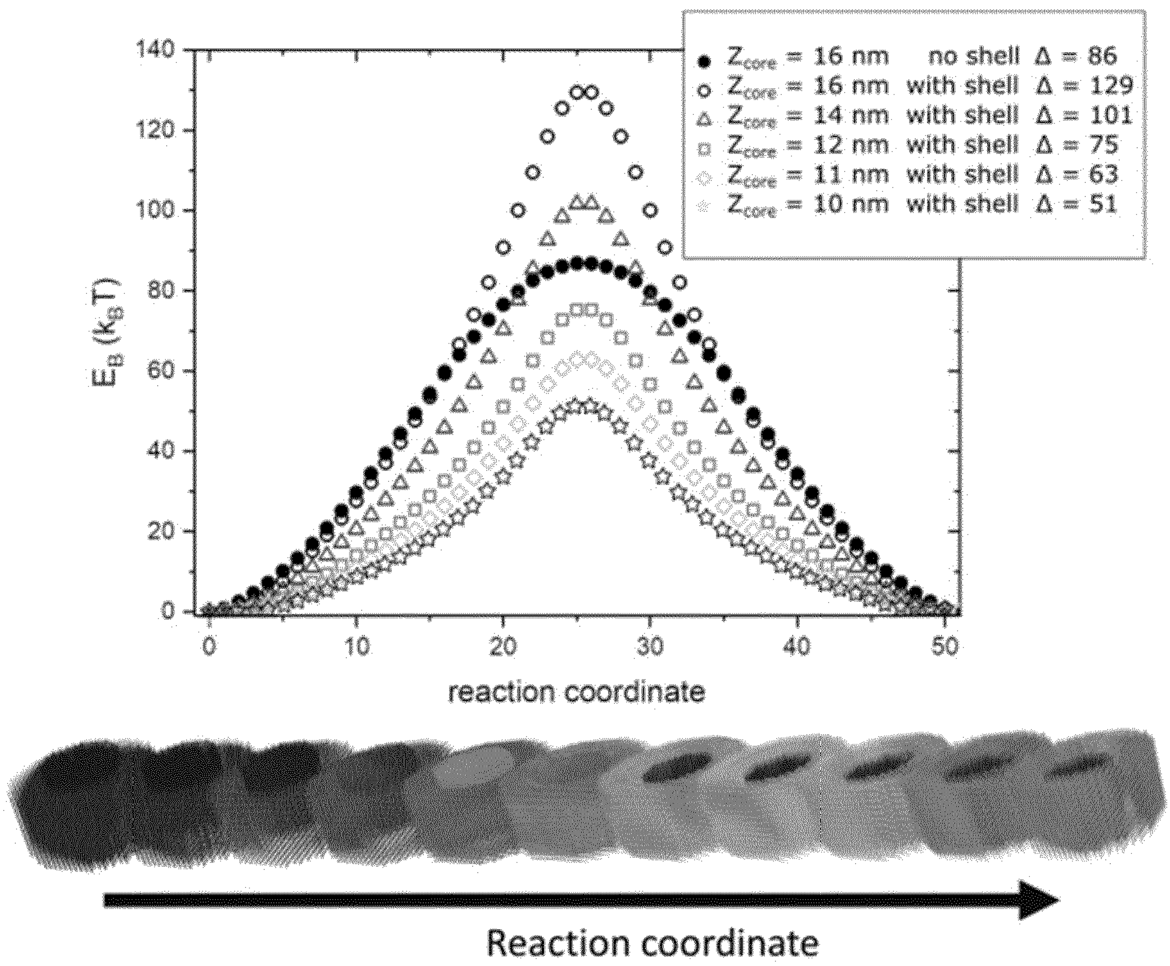
140
120
100
80
60
40
20
0
$E_B$ ($k_BT$)
0
10
20
30
40
50
reaction coordinate
$Z_{core}$ = 16 nm no shell Δ = 86
$Z_{core}$ = 16 nm with shell Δ = 129
$Z_{core}$ = 14 nm with shell Δ = 101
$Z_{core}$ = 12 nm with shell Δ = 75
$Z_{core}$ = 11 nm with shell Δ = 63
$Z_{core}$ = 10 nm with shell Δ = 51
Reaction coordinate

FIG. 9A

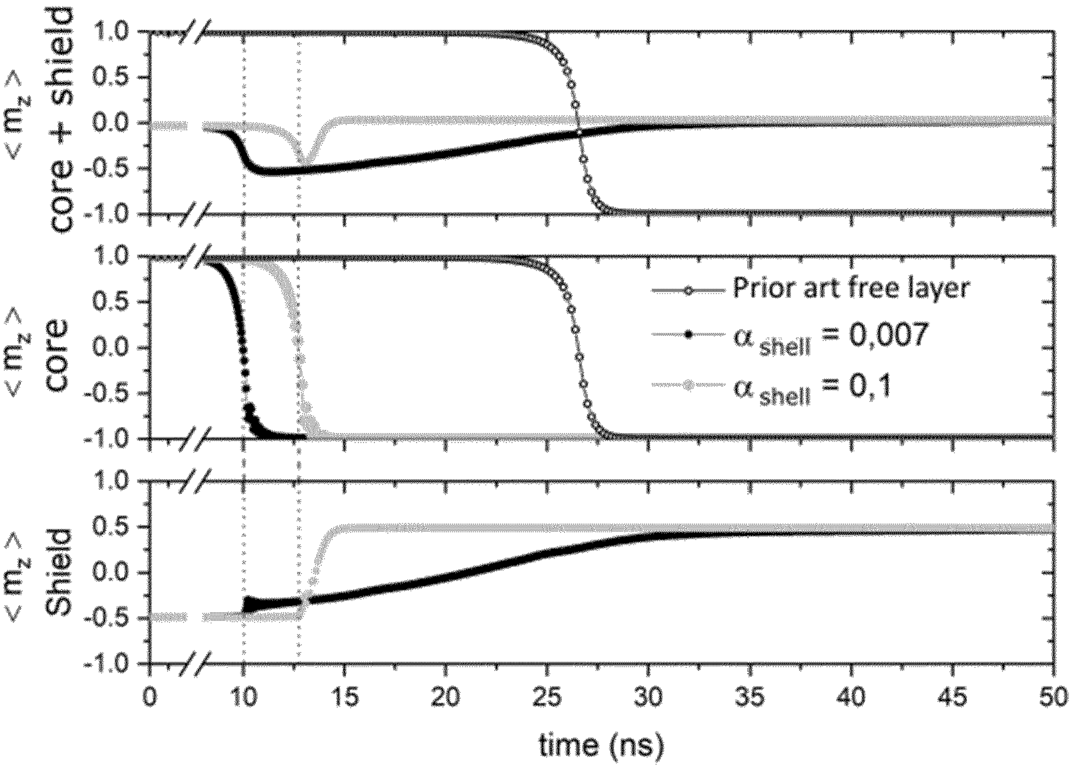
< m_z >
core + shield
< m_z >
core
< m_z >
Shield
1.0
0.5
0.0
-0.5
-1.0
0
10
15
20
25
30
35
40
45
50
time (ns)
Prior art free layer
α shell = 0,007
α shell = 0,1

FIG. 9B

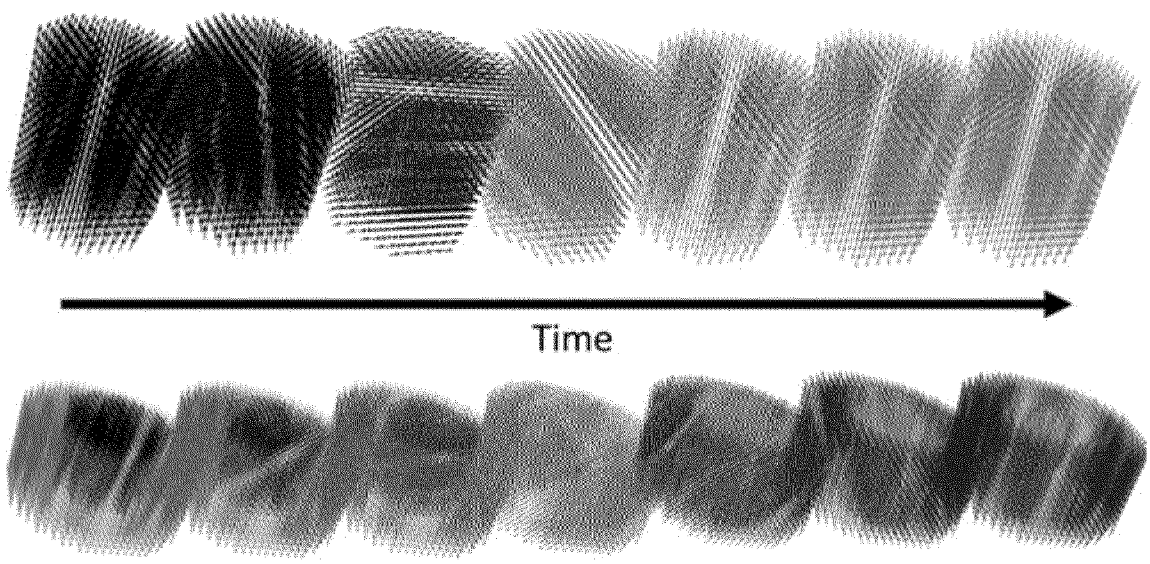
Time

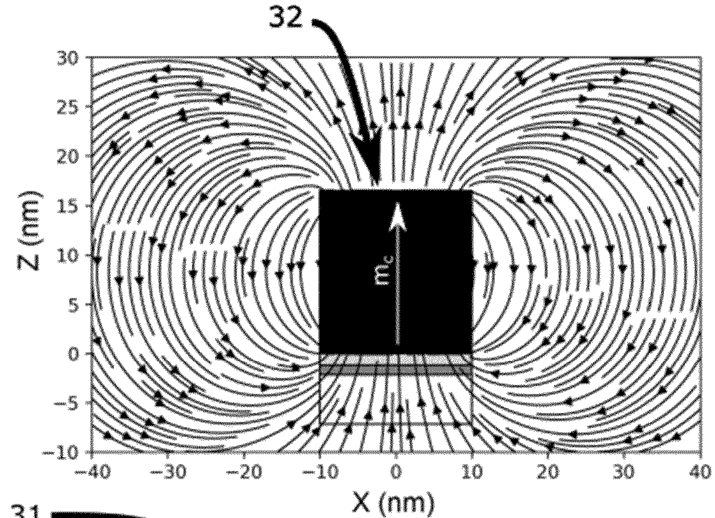


FIG. 10A

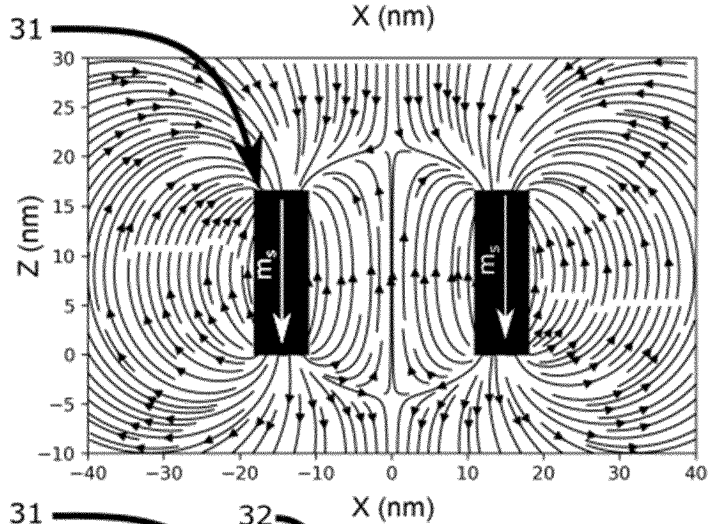


FIG. 10B

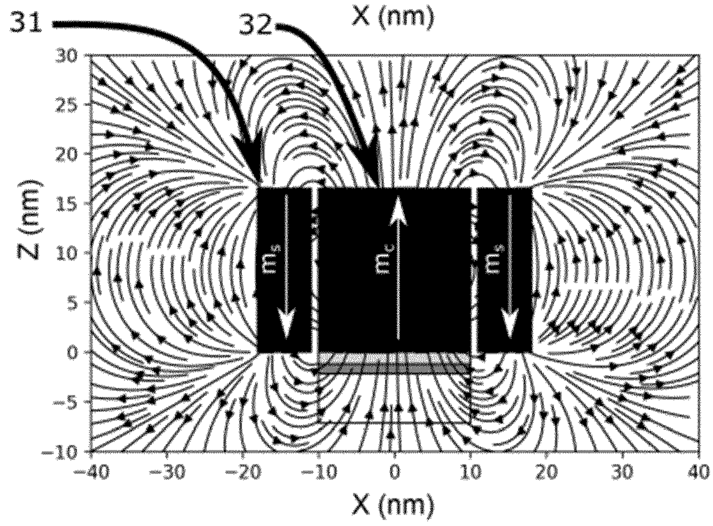


FIG. 10C

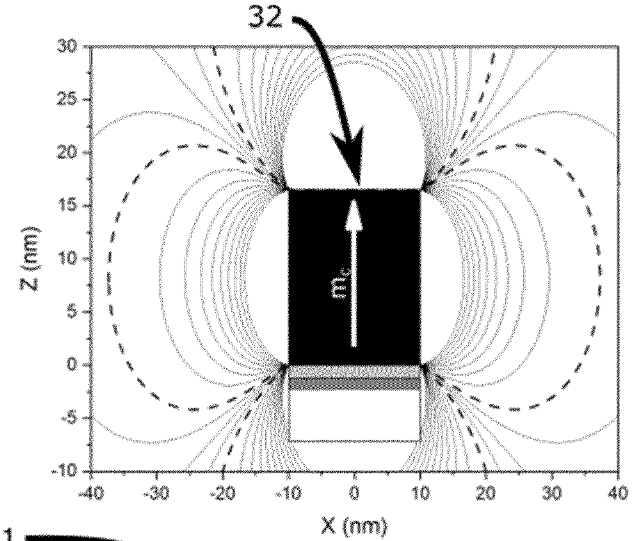


FIG. 11A

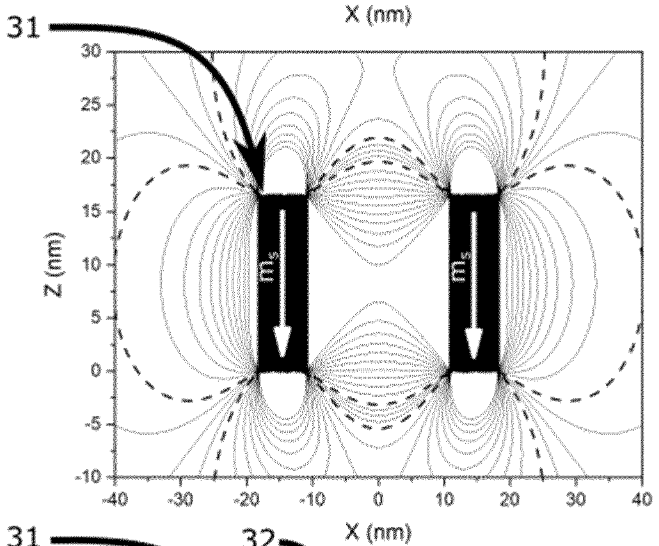


FIG. 11B

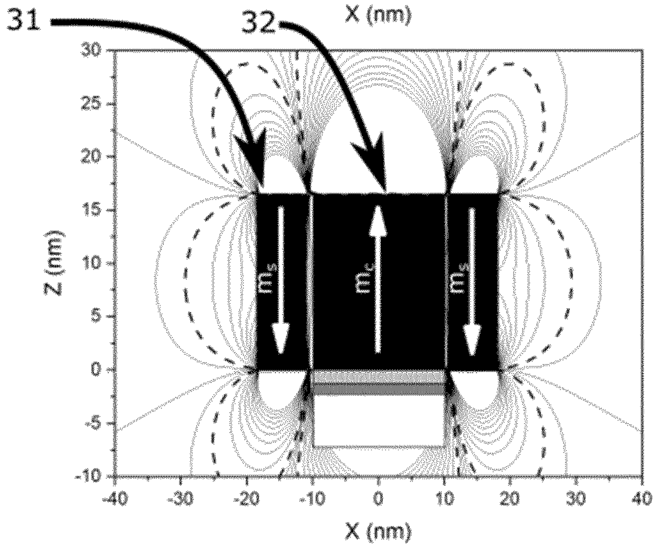


FIG. 11C

FIG. 12A

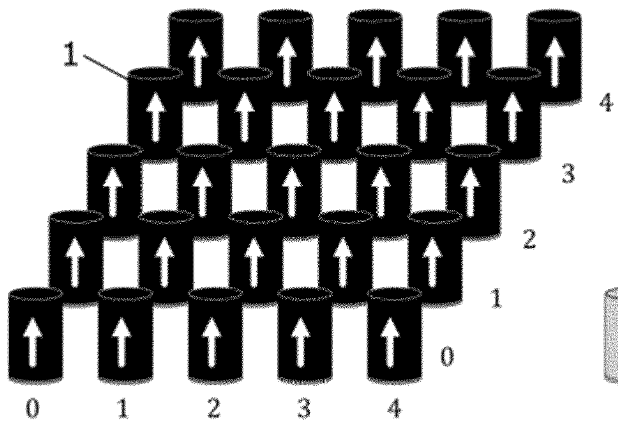


FIG. 12B

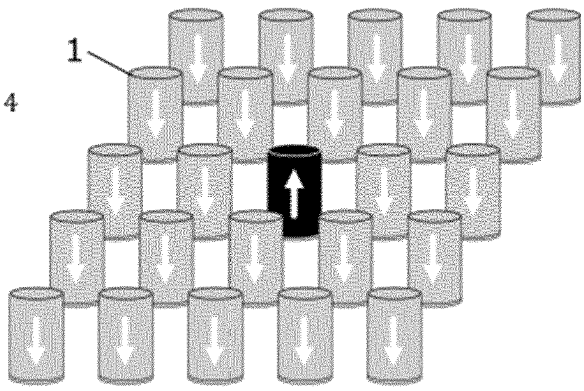


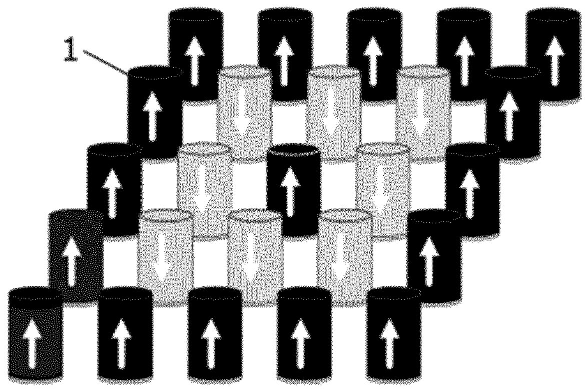


FIG. 12C

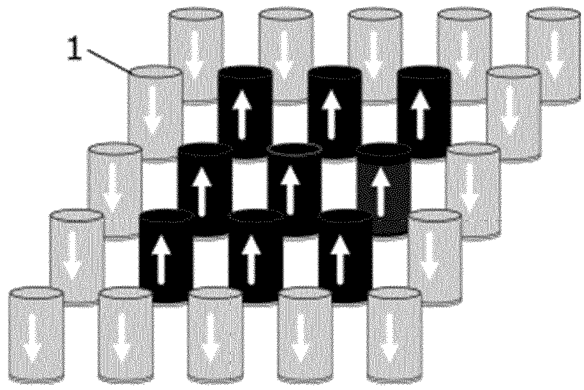


FIG. 12D

FIG. 13A

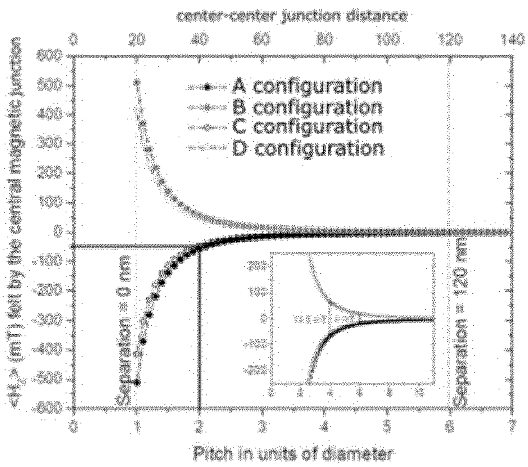


FIG. 13B

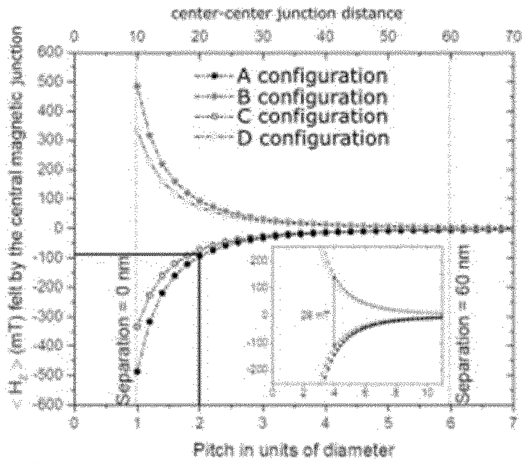


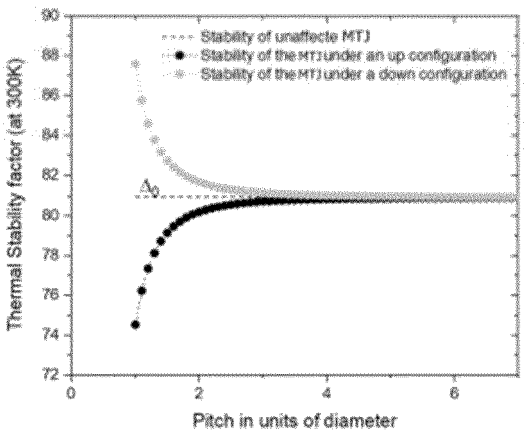


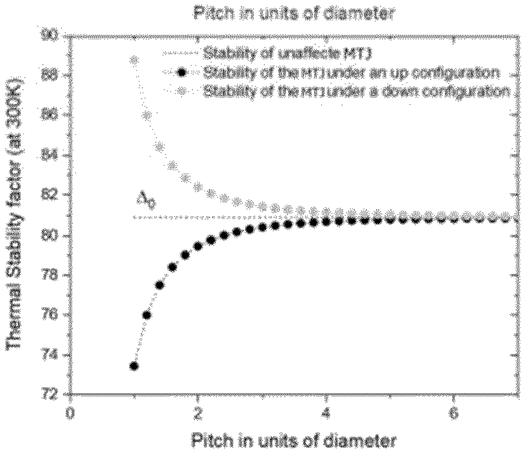


FIG. 13C

FIG. 13D

FIG. 14A

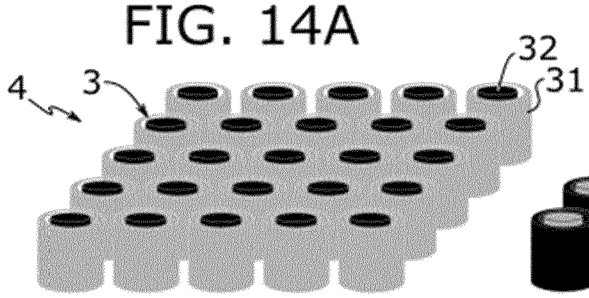


FIG. 14B

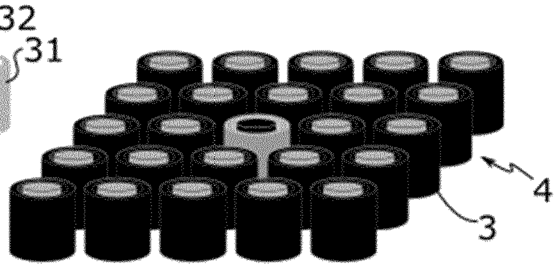


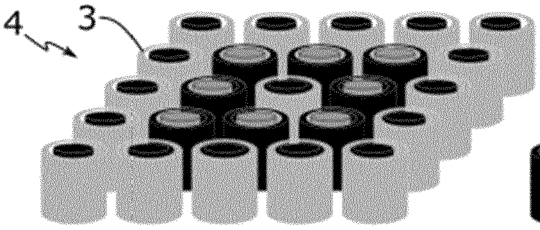


FIG. 14C

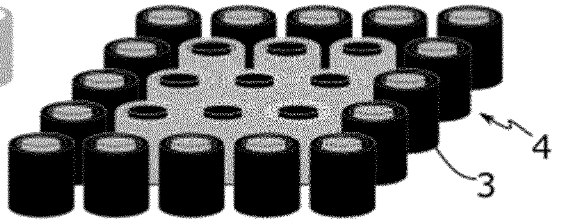


FIG. 14D

FIG. 15A

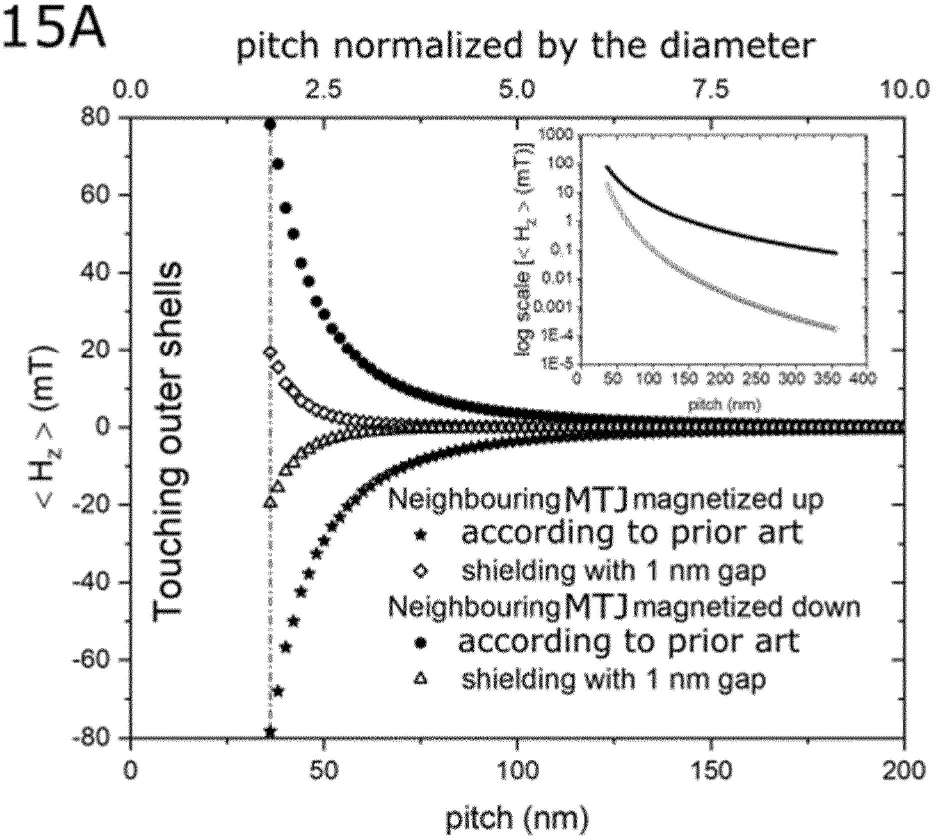


FIG. 15B

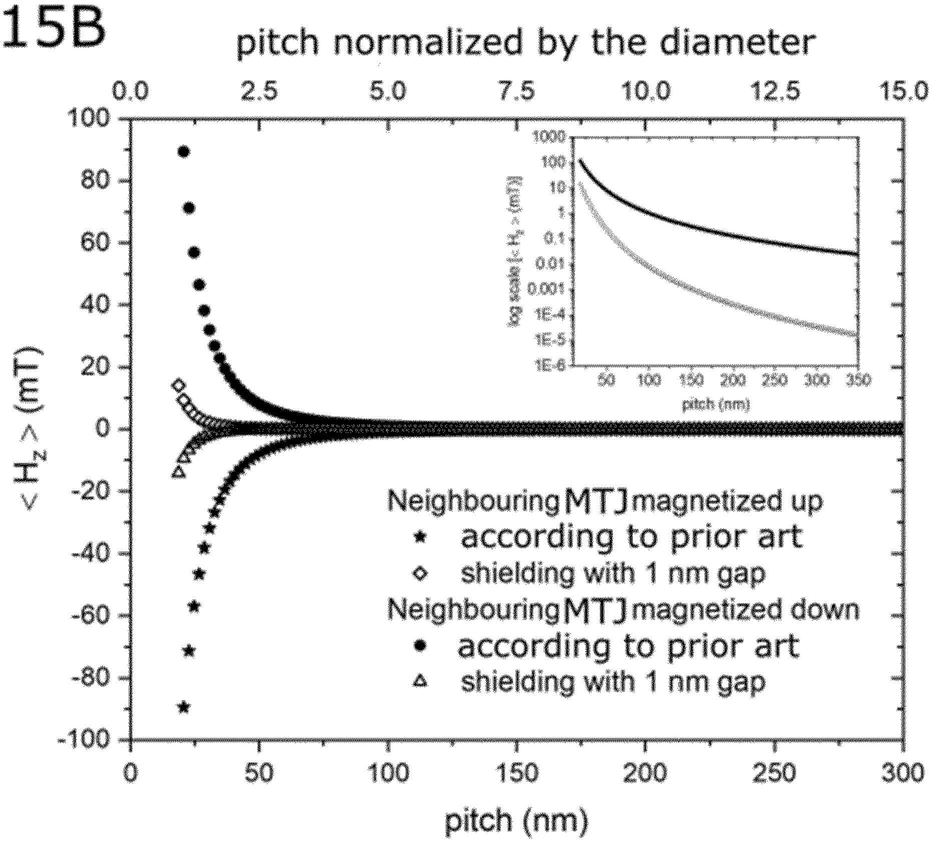

FIG. 16

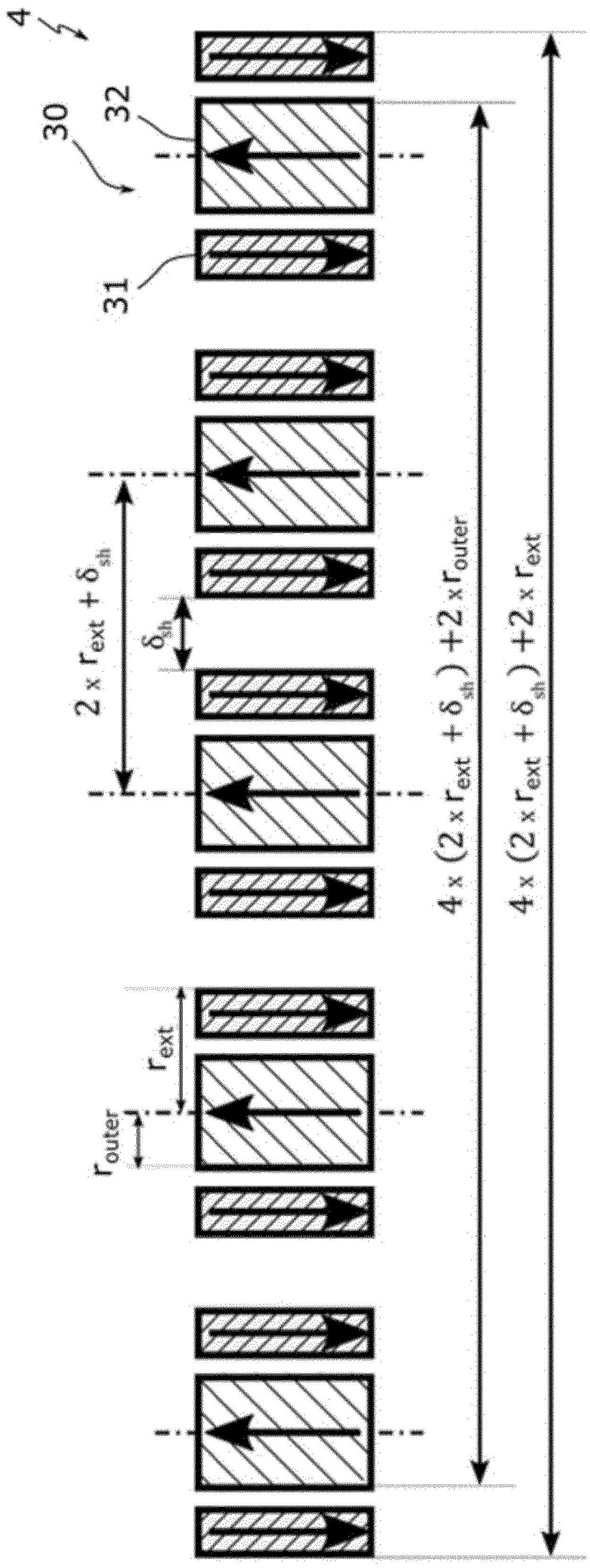
4
30
32
31
$2 \times r_{ext} + \delta_{sh}$
$\delta_{sh}$
$r_{ext}$
$r_{outer}$
$4 \times (2 \times r_{ext} + \delta_{sh}) + 2 \times r_{outer}$
$4 \times (2 \times r_{ext} + \delta_{sh}) + 2 \times r_{ext}$

FIG. 17

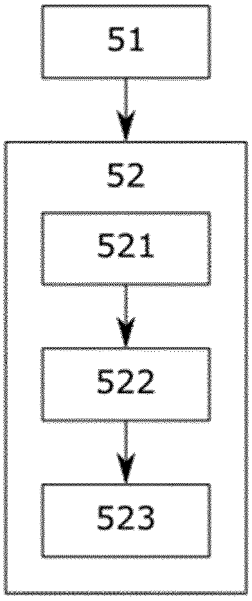


FIG. 18A

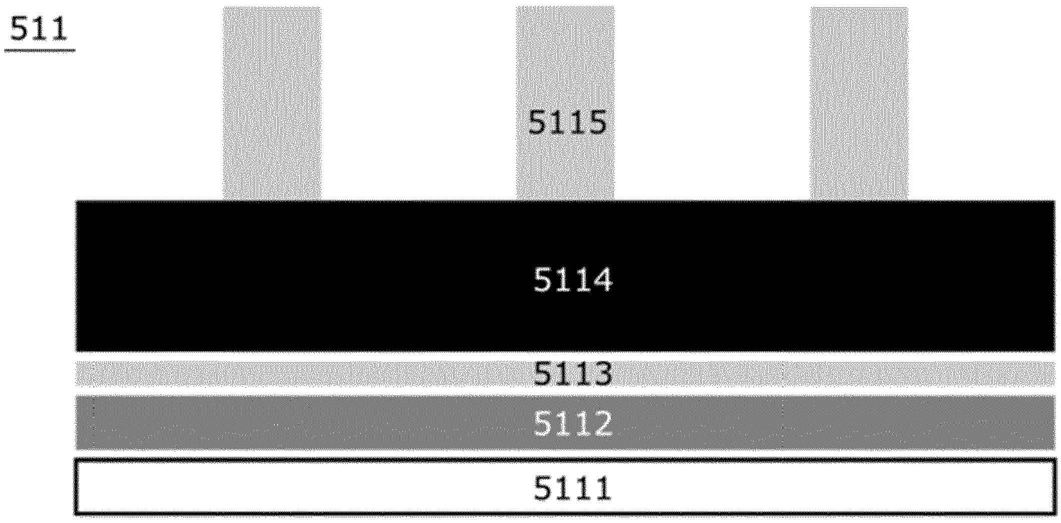

FIG. 18B

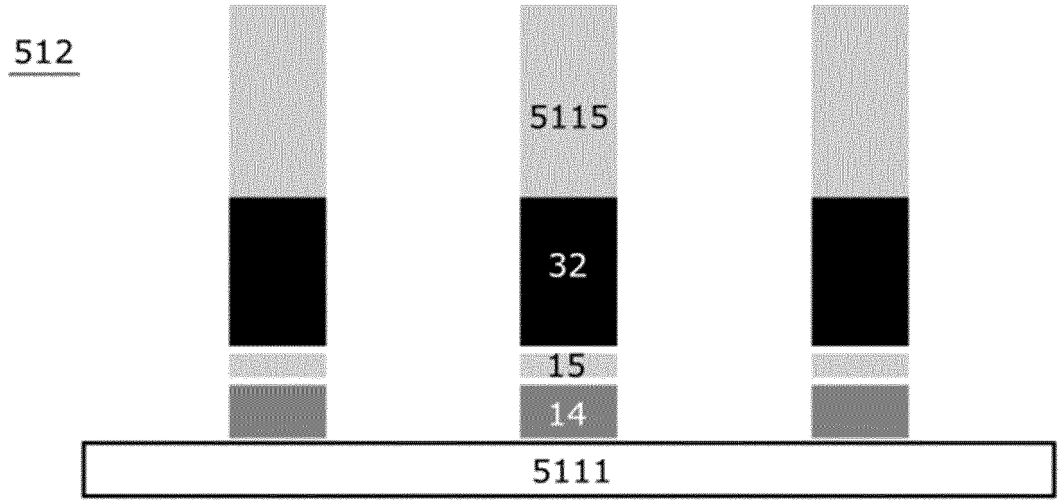


FIG. 18C

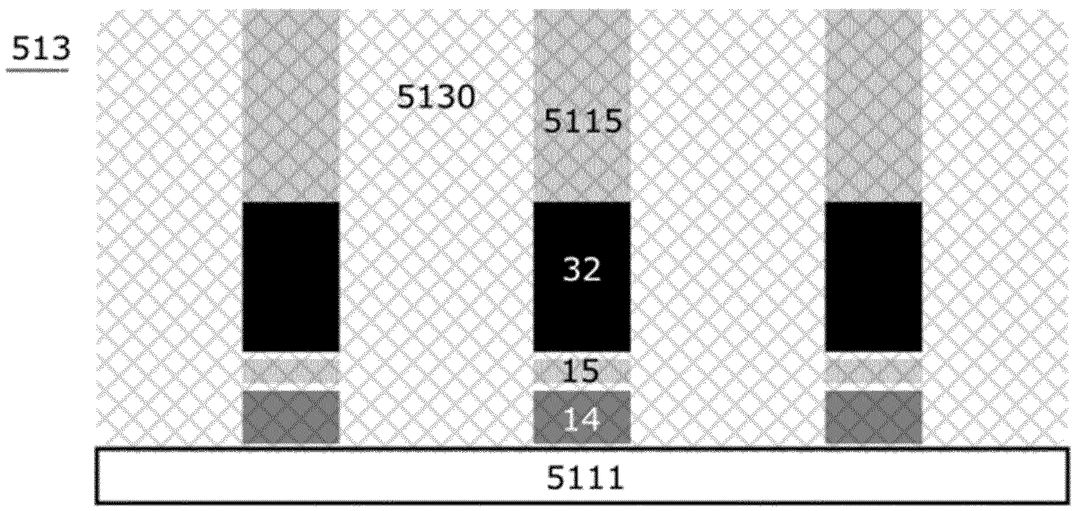

FIG. 18D

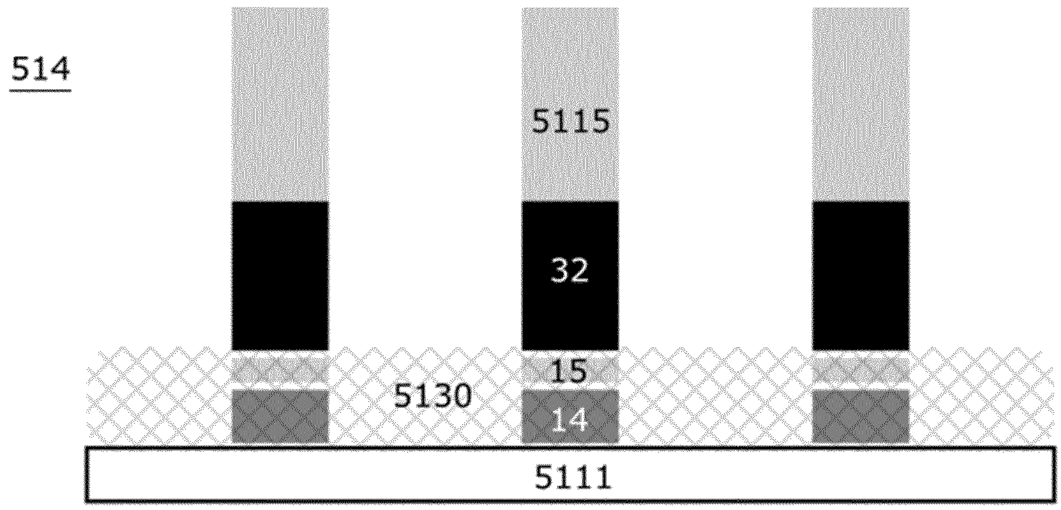


FIG. 18E

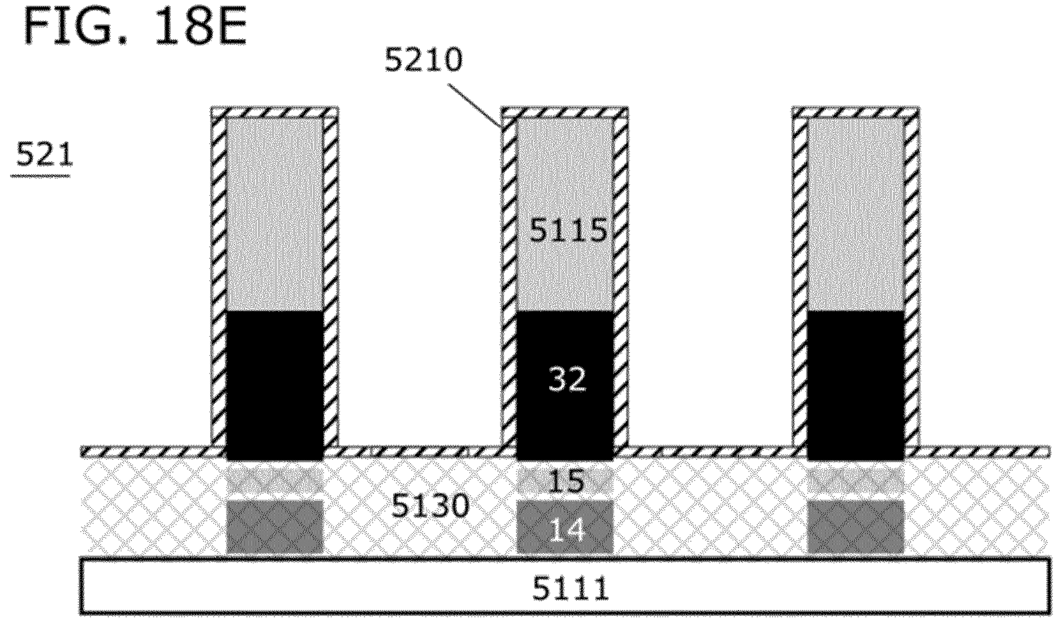

FIG. 18F

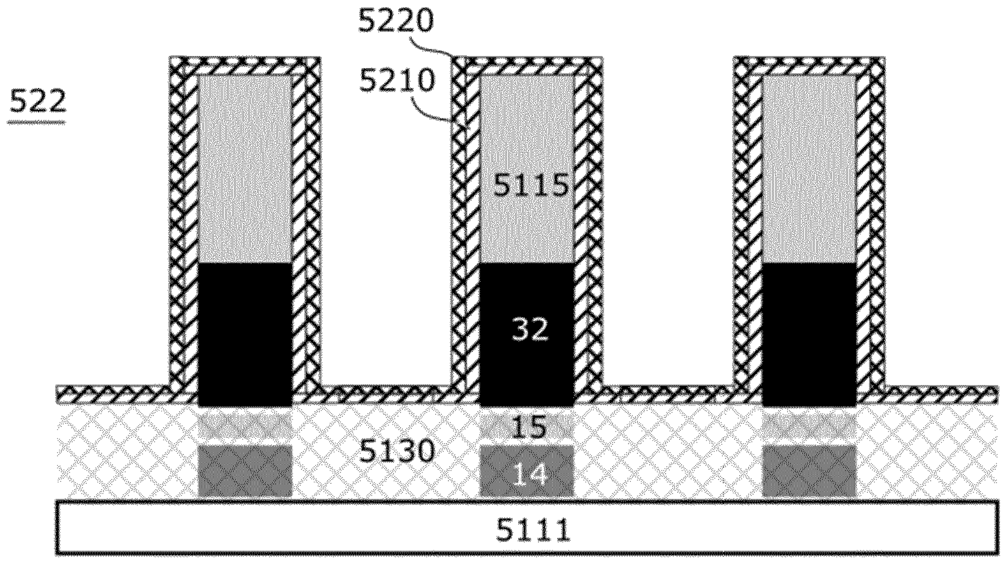


FIG. 18G

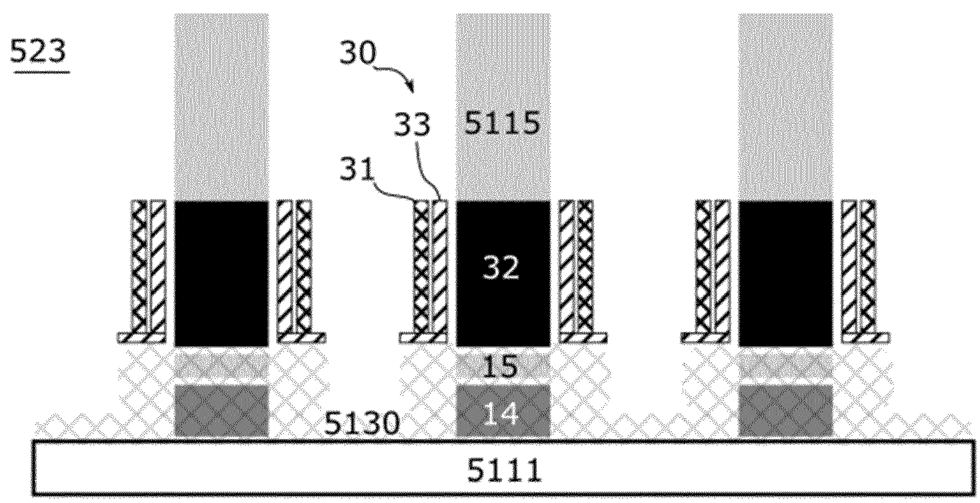

FIG. 18H

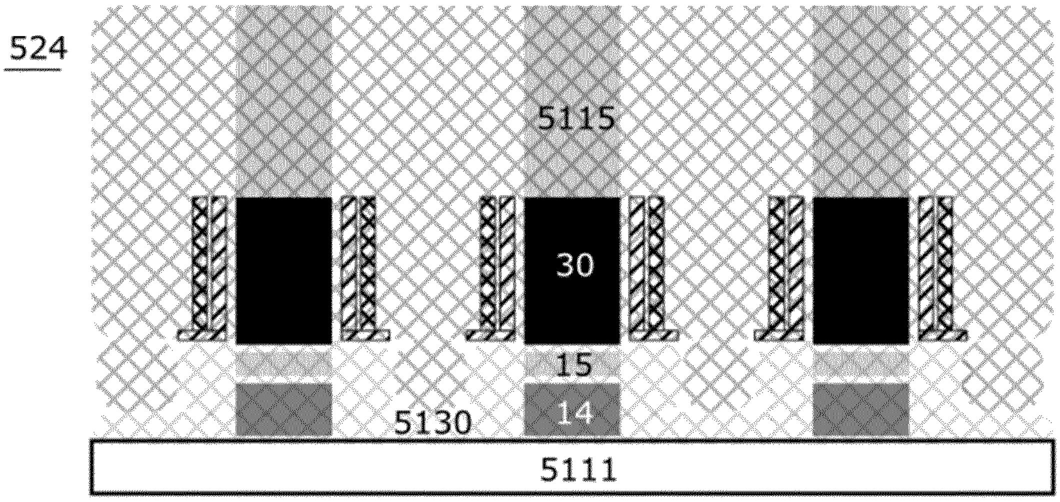


FIG. 18I

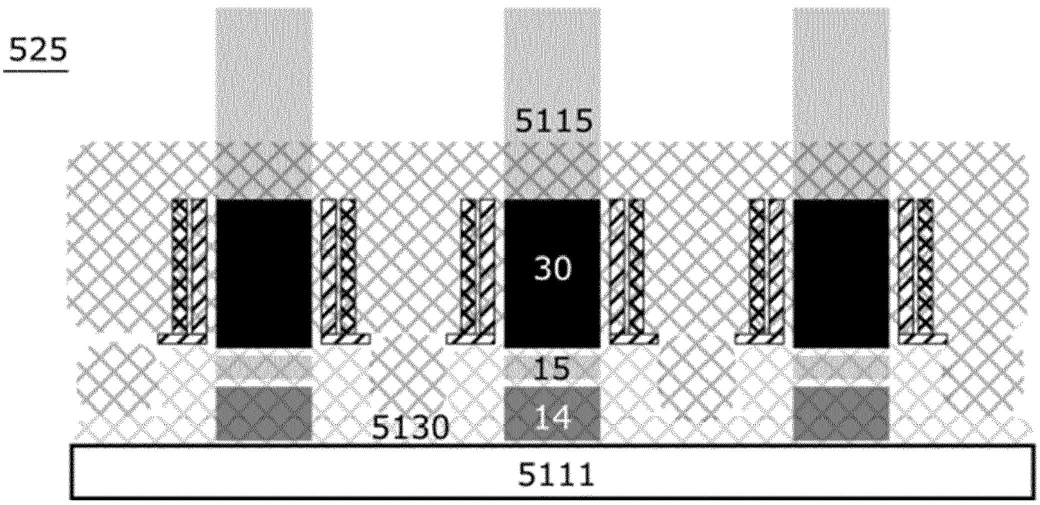

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6531723 B1
- US 20190326508 A1


### Non-patent literature cited in the description


- **Y.K. HA et al.** MRAM with novel shaped cell using synthetic anti-ferromagnetic free layer. *2004 Symposium on VLSI Technology*, 24-25
- **N. PERRISSIN**. A highly thermally stable sub-20 nm magnetic random-access memory based on perpendicular shape anisotropy. *Nanoscale*, 2018, vol. 10, 12187-12195
- **M. BELEGGIA et al.** Demagnetizing factors for cylindrical shells and related shapes. *Journal of Magnetism and Magnetic Materials*, 2009, vol. 321, 1306-1315
- **N. CAÇOILO et al.** Spin-Torque-Triggered Magnetization Reversal in Magnetic Tunnel Junctions with Perpendicular Shape Anisotropy. *Physical Review Applied*, 2021, vol. 16, 024020